## Europäisches Patentamt

## European Patent Office

## Office européen des brevets

(11) Veröffentlichungsnummer: **0 191 431**
B1

(12) # EUROPÄISCHE PATENTSCHRIFT

(45) Veröffentlichungstag der Patentschrift:
02.11.89

(51) Int. Cl.⁴: **G01N 24/08**

(21) Anmeldenummer: **86101597.2**

(22) Anmeldetag: **07.02.86**

(54) Verfahren und Einrichtung zur schnellen Akquisition von Spinresonanzdaten für eine ortsaufgelöste Untersuchung eines Objekts.

(30) Priorität: **12.02.85 DE 3504734**

(43) Veröffentlichungstag der Anmeldung:
**20.08.86 Patentblatt 86/34**

(45) Bekanntmachung des Hinweises auf die Patenterteilung:
**02.11.89 Patentblatt 89/44**

(84) Benannte Vertragsstaaten:
**AT BE CH DE FR GB IT LI LU NL SE**

(56) Entgegenhaltungen:
EP-A- 0 103 397
EP-A- 0 121 312
EP-A- 0 137 420
US-A- 4 318 043

I.E.E.E. SPECTRUM, Band 20, Nr. 2, Februar 1983,
Seiten 32-38, New York, US; P.A. BOTTOMLEY "Nuclear
magnetic resonance: beyond physical imaging"
PROCEEDINGS OF THE IEEE, Band 70, Nr. 10,
Oktober 1982, Seiten 1152-1173, New York, US; Z.H.
CHO et al.: "Fourier transform nuclear magnetic
resonance tomographic imaging"
SPEKTRUM DER WISSENSCHAFT, Juli 1982,
Seiten 40-55; I.L. PYKETT "Kernspintomographie:
Röntgenbilder ohne Röntgenstrahlen"

(73) Patentinhaber: **Max-Planck-Gesellschaft zur Förderung
der Wissenschaften e.V., Bunsenstrasse 10,
D-3400 Göttingen(DE)**

(72) Erfinder: **Frahm, Jens, Dr., Beethovenstrasse 25,
D-3400 Göttingen(DE)**
Erfinder: **Haase, Axel, Dr., Stiegel 5,
D-3400 Göttingen(DE)**
Erfinder: **Matthaei, Dieter, Dr., Hanssenstrasse 17,
D-3400 Göttingen(DE)**
Erfinder: **Hänicke, Wolfgang, Gartenstrasse 3,
D-3400 Göttingen(DE)**
Erfinder: **Merboldt, Klaus-Dietmar, Dr., Brunnengasse 2,
D-3400 Göttingen(DE)**

(74) Vertreter: **von Bezold, Dieter, Dr. et al, Dr. Dieter von
Bezold Dipl.-Ing. Peter Schütz Dipl.-Ing. Wolfgang
Heusler Brienner Strasse 52, D-8000 München 2(DE)**

## Beschreibung

Die vorliegende Erfindung betrifft ein Verfahren und eine Einrichtung zur schnellen Akquisition von Spinresonanzdaten für eine ortsaufgelöste Untersuchung eines Objekts mittels magnetischer Resonanz von atomaren Spinmomenten. Das vorliegende Verfahren eignet sich vor allem, jedoch nicht ausschließlich, für die schnelle abbildende Kernspinresonanz- (NMR-) Tomografie. Da das vorliegende Verfahren schnell ist und mit kleinen Flipwinkeln arbeitet, soll es als "fast low angle shot" Verfahren (Akronym "FLASH") bezeichnet werden.

Die Grundlagen der räumlich aufgelösten magnetischen Kernresonanz sind beispielsweise in einem Artikel von I.L. Pykett in der DE-Zeitschrift "Spektrum der Wissenschaft" Juli 1982, S.40 bis 55 erläutert. Genauere Einzelheiten können einer Monographie von P. Mansfield und P.G. Morris "NMR Imaging in Biomedicine", Academic Press, New York, 1982 entnommen werden.

Um kurz zu rekapitulieren, wird bei bilderzeugenden NMR-Verfahren das zu untersuchende Objekt in ein homogenes, statisches ("longitudinales") Magnetfeld ($B_0$-Feld) gebracht, das die Kernspins in der Probe in eine Z-Richtung parallel zum $B_0$-Feld ausrichtet, so daß eine Magnetisierung in dieser Richtung resultiert. Dieses konstante, homogene $B_0$-Feld ist bei allen NMR-Verfahren während des ganzen Experiments vorhanden, was im folgenden meist stillschweigend vorausgesetzt wird. Das Objekt wird dann mit einem Hochfrequenzpuls (RF-Puls) bestrahlt, durch den, klassisch betrachtet, die Spins um einen von der Amplitude und der Dauer des RF-Pulses abhängigen Winkel (Flip-Winkel) aus der Z-Richtung herausgekippt werden. Die Spins beginnen dann mit der sog. Larmor-Frequenz um die Z-Richtung zu präzedieren und ihre Transversal-Komponente in der zur Z-Richtung senkrechten Ebene (XY-Ebene) kann als Ausgangssignal detektiert werden. Bei einem Flipwinkel von 90 Grad wird die gesamte Magnetisierung in die XY-Ebene umgeklappt, das Ausgangssignal hat dann seine maximale Amplitude. Ein Flipwinkel von 180° kehrt die Richtung der Magnetisierung bzw. Spins um.

Bei NMR-Verfahren spielen drei Relaxationszeiten eine wesentliche Rolle, nämlich die Spin-Gitter-Relaxationszeit $T_1$, die Spin-Spin-Relaxationszeit $T_2$ und die effektive Spin-Spin-Relaxationszeit $T_2^*$. Zur Codierung von Ortsinformation in das Ausgangssignal und zur Erzeugung bestimmter Ausgangssignale, insbesondere der sog. Gradienten-Echos, dienen drei im wesentlichen aufeinander senkrecht stehende Magnetfeldgradienten, deren Amplitude und Dauer steuerbar sind. Weitere Einzelheiten sind in den obengenannten Veröffentlichungen sowie der umfangreichen Patentliteratur enthalten und werden im folgenden besprochen, soweit sie für die vorliegende Erfindung von Bedeutung sind.

Ein ständiges Bestreben seit der Erfindung der Kernspin-Tomografie besteht darin, die Zeitdauer (Akquisitionszeit) zu verringern, die für die Gewinnung der zur Bildrekonstruktion erforderlichen NMR-Daten nötig ist. Weitere wichtige Merkmale eines bilderzeugenden NMR-Verfahren sind die räumliche Auflösung (also die Abmessungen der elementaren Bildelemente oder Pixels des rekonstruierbaren Bildes) und das Signal/Rausch-Verhältnis (SNR).

Ein sehr schnelles NMR-Tomographie-Verfahren ist die von P. Mansfield et al in J. Magn. Reson. **29**, 355-373 (1978) beschriebene Methode des "Echo Planar Imaging", die auf einer Erfassung des vollständigen FID-Signals (FID = freier Induktionsabfall), d. h. des FID-Signales als Ganzes, in Anwesenheit eines alternierenden Gradienten und eines konstanten Gradienten bestimmter Stärke nach einer Anregung mit einem einzigen Hochfrequenzpuls. Bei diesem Verfahren, das auch Gegenstand der US-A-4,115,730 und US-A-4,165,479 ist, ist jedoch das räumliche Auflösungsvermögen physikalisch begrenzt und läßt sich auch durch eine Verlängerung der Meßzeit nicht über eine bestimmte Grenze hinaus verbessern. Auch das Signal/Rausch-Verhältnis läßt noch zu wünschen übrig.

Weitere schnelle bilderzeugende NMR-Verfahren, die mit stimulierten Spin-Echos arbeiten, sind in der europäischen Patentanmeldung Nr. 85115818.8 vorgeschlagen worden.

Durch die in den Patentansprüchen gekennzeichnete Erfindung wird die Aufgabe gelöst, ein Verfahren und eine Einrichtung zur schnellen Akquisition von Spinresonanzdaten für eine zwei- oder dreidimensionale Bilddarstellung anzugeben, welches die Vorteile einer für viele praktische Anwendungen ausreichend kurzen Meßzeit, eines hohen räumlichen Auflösungsvermögens und eines guten Signal/Rausch-Verhältnisses in bisher nicht erreichbarer Weise vereinigt.

Bei dem vorliegenden Verfahren wird durch Hochfrequenz- oder Anregungspulse, deren Flipwinkel wesentlich kleiner als 90° ist, nur ein relativ kleiner Bruchteil der durch das konstante $B_0$-Magnetfeld in die Z-Richtung ausgerichteten Magnetisierung bzw. Spins in die XY-Ebene umgeklappt und die umgeklappten Spins werden durch Gradientenschaltung möglichst vollständig zur Erzeugung eines oder mehrerer Gradienten-Echos verwendet. Da der überwiegende Teil der Spins noch in der Z-Richtung orientiert ist und daher noch ein großer Vorrat an Z-Magnetisierung zur Verfügung steht, kann nach der Erfassung des Echos sofort ein neuer "Teilanregungsimpuls" zur Einwirkung gebracht werden, der wieder nur einen kleinen Bruchteil der in Z-Richtung orientierten Spins in die XY-Richtung umklappt ohne daß man vorher, wie es bisher erforderlich war, eine Erholungsperiode in der Größenordnung von $T_1$ verstreichen lassen muss. Es hat sich überraschenderweise gezeigt, daß sich in kurzer Zeit ein Gleichgewichtszustand in der Spin-Besetzung der Z-Richtung einstellt und daher ein praktisch unerschöpfliches Reservoir von Spins, die in kurzen Abständen teilweise angeregt und zur Erzeugung gleichwertiger Gradienten-Echosignale verwendet werden können, zur Verfügung steht. Welcher Flipwinkelbereich bei einer speziellen Anwendung zweckmäßig ist, hängt bis zu einem gewissen Grad von der Stärke des $B_0$-Fel-

des, den Spin-Gitter-Relaxationszeiten $T_1$ und den gewünschten $T_1$-Kontrasten ab. Flipwinkel unter 75 Grad sind gut geeignet; der Bereich von 10 bis 50 Grad hat sich als besonders zweckmäßig erwiesen. Beispielsweise sind für ein $B_0$-Feld in der Größenordnung von 2 bis 3 Tesla (T) im allgemeinen Flipwinkel von etwa 15 bis 30 Grad vorteilhaft. Das vorliegende Verfahren kann also als "Gradienteninversionsverfahren mit kleinem Flipwinkel und kleiner Hochfrequenzleistung" bezeichnet werden und ist bei allen Feldstärken des $B_0$-Feldes anwendbar.

Generell gesagt wird der Flipwinkel um soviel kleiner als 90 Grad und der zeitliche Abstand aufeinanderfolgender HF-Pulse so klein gewählt, daß sich ein Gleichgewichtszustand zwischen der verbleibenden Längsmagnetisierung und der durch die HF-Pulse erzeugten Quermagnetisierung einstellt, bei dem die Längsmagnetisierung überwiegt und für jeden HF-Puls wenigstens annähernd der gleiche, für die Erzeugung eines detektierbaren Gradientenecho-Signales ausreichende Betrag an Längsmagnetisierung zur Verfügung steht, ohne daß zwischen die aufeinanderfolgenden signalerzeugenden HF-Pulse Relaxationszeiten oder Auffüll-bzw. Wiederherstellungsimpulse für die Längsmagnetisierung eingeschaltet werden müssen.

Eine bevorzugte Ausführungsform des erfindungsgemäßen Verfahrens ist Gegenstand des Anspruchs 1 und eine bevorzugte Ausführungsform der erfindungsgemäßen Einrichtung ist Gegenstand des Anspruchs 13.

Die Signaldetektion erfolgt durch Abtasten (Sampling) des Gradienten-echo-Signales unter Erzeugung einer Vielzahl von Proben, die kurz im Vergleich zur Lesedauer sind.

Die Zeitspanne gem. Verfahrensschritt h) ist vorzugsweise höchstens 20 Millisekunden (ms), zweckmäßigerweise höchstens 10 ms.

Sowohl die Verwendung von Flipwinkeln, die kleiner als 90° sind, als auch die Erzeugung von Gradienten-Echos durch Umkehren eines Magnetfeld-Gradienten ("Lesegradienten") sind für sich und in anderem Zusammenhang schon seit langem bekannt.

Flipwinkel von weniger als 90° werden z. B. bei dem sogenannten SFP- (steady state free precession) Verfahren verwendet (W.S. Hinshaw, J. Appl. Phys. **47**, No. 8, August 1967), das auf einer Arbeit von H. Y. Carr aus dem Jahre 1958 basiert (Phys. Rev. **112**, 1693-1701, 1958). Bei diesem SFP-Verfahren wird die Probe mit einer Folge von HF-Pulsen bestrahlt, deren Abstände klein im Vergleich zur Spin-Gitter-Relaxationszeit und klein im Vergleich zur Spin-Spin-Relaxationszeit sind. Das sich im Gleichgewichtszustand zwischen den HF-Pulsen einstellende Signal liefert nur Information über einen einzigen Raumpunkt der Probe. Dieses Verfahren ist daher extrem zeitaufwendig, da schon Bilder mit mäßiger Auflösung Akquisitionszeiten in der Größenordnung von Stunden erfordern.

Auch beim Echo-Planar-Imaging-Verfahren (l.c.) können HF-Anregungspulse mit Flipwinkeln, die kleiner als 90° sind, verwendet werden. Hier werden jedoch ein alternierender Gradient ($G_y$) sowie ein konstanter Gradient ($G_z$) nach Beendigung des HF-Pulses bis zum Ende der Daten-Akquisition aufrechterhalten. Die Bilderzeugung bei diesem Verfahren unterscheidet sich von anderen Verfahren dadurch wesentlich, daß durch Fourier-Transformation des periodisch abfallenden und ansteigenden FID-Signales ein diskretes Projektionsprofil des Objekts erzeugt wird. Der konstante Gradient ($G_z$) wirkt als Lesegradient. Um das diskrete Projektionsprofil nicht zu zerstören muß er klein sein im Vergleich zur Stärke des alternierenden Gradienten, wodurch die mit diesem Verfahren erreichbare räumliche Auflösung ebenfalls begrenzt wird. Im Gegensatz hierzu können bei dem erfindungsgemäßen Verfahren alle Gradienten die gleiche Größe bzw. Größenordnung haben.

Die Erzeugung von Daten zu Rekonstruktion von Schichtbildern mit Hilfe von Gradienten-Echos ist aus der Veröffentlichung von Edelstein et al, Phys. Med. Biol. **25**, 751-756 (1980) und en PCT-Veröffentlichungen W081-02788 und W081-02789 bekannt. Bei diesem sogenannten "Spin-Warp"- Verfahren, das auch unter den Bezeichnungen SR- oder RFID-Verfahren bekannt ist, wird durch einen 90°-HF-Puls und einen gleichzeitig zur Einwirkung gebrachten Schichtgradienten eine Schicht der Probe angeregt und anschließend werden durch Einschalten sowie ein- oder mehrmaliges Umschalten eines Lesegradienten ein bzw. mehrere Echo-Signale erzeugt, die nach der heutigen Nomenklatur als Gradienten-Echos zu bezeichnen sind. Vor dem Anlegen des nächsten HF-Pulses muß man eine System- Erholungsperiode verstreichen lassen, die lang im Vergleich zu $T_1$ sein muß und in der Größenordnung von einer Sekunde liegt. Dies macht das Verfahren für Fälle, in denen eine schnelle Daten-Akquisition erforderlich ist, unbrauchbar.

Aus EP-A 103 397 ist ein abgewandeltes Spin-Warp-Verfahren zum Gewinnen dreidimensionaler NMR-Bildinformation bekannt. Bei diesem Verfahren werden auf den abzubildenden Objektbereich zuerst ein 90°-Hochfrequenzpuls und gleichzeitig ein Magnetfeldgradient in Y-Richtung zur Einwirkung gebracht. Nach Beendigung des Hochfrequenzpulses wird die Polarität des Y-Magnetfeldgradienten umgekehrt, um das Freie-Induktionsabfall-Signal zu maximieren, wobei jedoch die Größe des Y-Gradientenpulses kleiner gewählt wird als es für eine vollständige Phasenrefokussierung der Spins erforderlich ist. Gleichzeitig werden ein Magnetfeldgradient in X-Richtung zur Dephasierung des Spins in X-Richtung, sowie ein Magnetfeldgradient in Z-Richtung zur Phasencodierung des Spins in Z-Richtung zur Einwirkung gebracht. Im anschließenden Interval wird der X-Magnetfeldgradient periodisch umgeschaltet, um die Spins in der Richtung dieses Gradienten zu refokussieren und Echosignale zu erzeugen. Der Gradient in Z-Richtung ist in diesem Interval gleich null. Zur Diskriminierung in Richtung des Y-Gradienten wird der Y-Gradient jeweils für eine Zeitspanne, die kurz gegen die X-Gradientenpulse alternierender Polarität ist, zur Einwirkung gebracht. Für die Bilderzeugung wird nur jedes zweite Echosignal verwendet. Vor dem nächsten Hochfrequenzpuls muß noch ein Systemerholungszeitintervall, das lang im Vergleich zur Spin-Gitter-Relaxationszeit ist, verstreichen.

Bei dem vorliegenden Verfahren liefert ein Gesamt-Experiment in einer relativ kurzen Zeitspanne einen vollständigen Datensatz zur Berechnung mindestens eines NMR-Tomogramms. Ein Gesamt-Experiment besteht aus einer Serie von Teil-Experimenten, die jeweils einen Hochfrequenzpuls mit einem Flipwinkel von deutlich kleiner als 90 Grad, z.B. kleiner als 75 Grad oder 50 Grad oder 25 Grad oder gegebenenfalls sogar kleiner als 15 Grad oder 5 Grad, ferner einen phasencodierenden Gradientenpuls und/oder mindestens einen alternierten Lesegradienten, und mindestens ein durch einen alternierten Lesegradienten erzeugtes Echosignal (Gradienten-Echo) enthalten. Alle Gradientenfelder werden zwischen dem Ende des anregenden Hochfrequenzpulses und dem Beginn der Datenerfassung ausgeschaltet oder im Falle von Lesegradienten in der Polarität umgeschaltet. Die Teil-Experimente können unmittelbar nach Beendigung der Aufnahme der Daten des Gradienten-Echosignals (d.h. nach ca. 10 bis 20 ms) aufeinanderfolgen. Damit entfallen die sonst üblichen Wartezeiten (Repetitionszeiten) in der Größenordnung der Spin-Gitter-Relaxationszeit $T_1$ (ca. 0,5 bis 2,0 s) vollständig.

Besondere Vorteile des vorliegenden erfindungsgemäßen Verfahrens sind:

(1) extrem geringe Hochfrequenzbelastungen dadurch, daß für jedes Teil-Experiment nur ein einziger Hochfrequenzpuls mit einem Flipwinkel von deutlich kleiner als 90 Grad benutzt wird;

(2) besonders gutes Signal-Rausch-Verhältnis, da sowohl eine Sättigung der zu den Gradienten-Echosignalen beitragenden Magnetisierung durch Verwendung von Bruchteilpulsen vermieden werden kann und daher stets ein hoher Anteil an Gleichgewichtsmagnetisierung (steady-state) durch die $T_1$-Relaxation von bereits durch das Experiment verbrauchten Magnetisierungsanteilen erhalten werden kann;

(3) die Eignung zu uneingeschränkt kontinuierlicher Bildgebung wegen des bereits unter (2) angeführten dynamischen Gleichgewichtszustandes;

(4) die sich daraus ergebende Möglichkeit, einen vollständig beliebigen Kompromiß zwischen zeitlicher und räumlicher Auflösung der NMR-Tomogramme einzugehen;

(5) die entstehenden NMR-Tomogramme enthalten $T_1$-Informationen, dadurch daß bei vorgegebenem Flipwinkel jedem $T_1$-Wert ein Gleichgewichtszustand mit anderer Amplitude entspricht. Durch Variation des Flipwinkels von Gesamt-Experiment zu Gesamt-Experiment kann eine unterschiedliche $T_1$-Wichtung erreicht werden;

(6) Wenn bei dem vorliegenden Verfahren pro HF-Puls nur ein einziges Gradienten-Echo erzeugt und datenmäßig erfaßt wird, sind die erzeugten Projektionen in der Signalstärke gleichmäßig intensiv, so daß die Auflösung im rekonstruierten Bild, insbesondere in Richtung des phasencodierenden Gradienten, überall gleich hoch ist:

(7) Dadurch, daß man ein Schichtbild mehrfach erzeugt (was nicht synchronisiert zu werden braucht) und die nacheinander erzeugten Schichtbilder einander überlagert, lassen sich Bewegungsartefakte weitestgehend vermeiden. So lassen sich beispielsweise deutliche, unverwischte enddiastolische Schichtbilder des Herzens oder Schichtbilder des Abdomens erzeugen. Entsprechendes gilt auch für 3D-Bilder, da auch hier Bewegungsartefakte durch Mittelung unterdrückt werden,

(8) freie Wahl der Zeit/Raum-Auflösung, z.B.
64x128 Pixel in ca. 1 s,
128x128 Pixel in ca. 2 s,
128x256 Pixel in ca. 3 s,
256x128 Pixel in ca. 4 s und
256x256 Pixel in ca. 6 s,
wobei sich diese Meßzeiten durch Optimierung der Gradientensystems noch reduzieren lassen.

(9) Erzeugung von NMR-Tomogrammen im Sekundenbereich mit variablen Kontrasten bei gleicher Meßzeit durch
- Variation des Flipwinkels der HF-Pulse zur $T_1$-Kontrastgebung;
- Variation der Auslesezeit des Gradienten-Echos zur $T_2^*$-Kontrastgebung;
- Erzeugung mehrerer Gradienten-Echos pro Anregung mit gleicher Phasencodierung zur $T_2^*$-Kontrastgebung;
- Verwendung geeigneter Substanzen, z.B. NMR-Kontrastmittel, Wasser Elektrolyte zur Beeinflussung von $T_1$ und/oder $T_2^*$;
- Verwendung zuzätzlicher HF-Pulse (z.B. 90°, 180°, CHESS usw.), die an einer oder wenigen Stellen eines Gesamt-Experimentes zwischen den Teil-Experimenten zur Einwirkung gebracht werden.

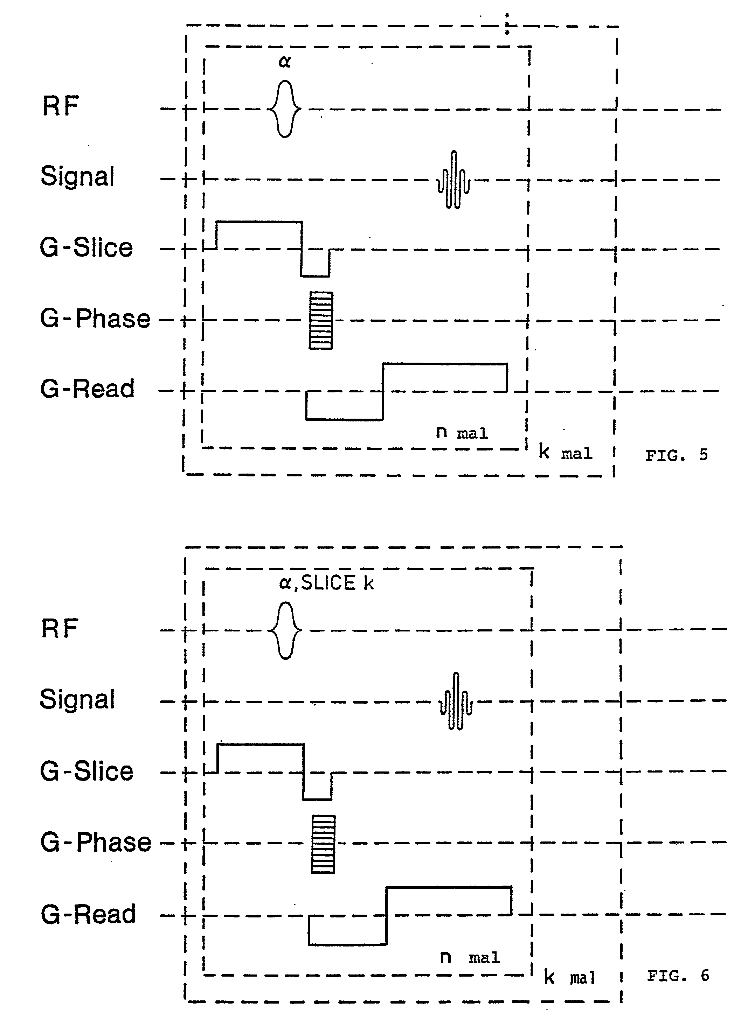

(10) Die Möglichkeit zeitlich sequentieller bildgebender Untersuchungen ("Filme") an lebenden Strukturen, insbesondere am Menschen, mit NMR-Tomogrammen im Sekundenbereich, und zwar Daten-Akquisitation für
- Bildsequenzen zeitlich direkt aufeinander folgender NMR-Tomogramme aus verschiedenen, z.B. direkt benachbarten Schichten (z. B. gemäß Fig. 6),
- Bildsequenzen zeitlich direkt aufeinander folgender NMR-Tomogramme aus einer Schicht (z. B. gemäß Fig. 5),
- Bildsequenzen der oben beschriebenen Art mit gleichzeitiger Applikation geeigneter Substanzen, (z. B. NMR-Kontrastmittel, Wasser Elektrolyte) zur Beeinflussung von $T_1$ und/oder $T_2^*$.

(11) die Möglichkeit der Gewinnung von Daten für bildgebende Untersuchungen zeitlich periodischer Vorgänge an lebenden Systemen, insbesondere am Menschen, mit NMR-Tomogrammen (siehe die folgende Beschreibung der Figuren 5 und 6) bei
- Verwendung von Trigger-Techniken zum jeweiligen Starten einer Serie von Teilexperimenten mit gleicher Phasencodierung, Wiederholung einer solchen Meßreihe mit veränderter Phasencodierung beim Auftreten des nächsten Triggerimpulses,
- Verwendung von Gating-Techniken, bei denen die Teilexperimente so lange durchlaufen, bis durch einen Triggerimpuls eine neue Folge von Teilexperimenten mit einer von Triggerimpuls zu Triggerimpuls geänderten Phasencodierung eingeleitet wird.

Ein Gesamt-Experiment der oben beschriebenen Typen ergibt dann jeweils eine Bildsequenz mit einem zeitlichen Abstand der Bilder, der der Dauer eines Teilexperiments entspricht.

(12) Die Möglichkeit der Kombination schneller bildgebender Untersuchungen an lebenden Systemen, insbesondere am Menschen, mit spektroskopischen, insbesondere räumlich lokalisierten spektroskopischen NMR-Verfahren in einem Time-Sharing-Experiment.

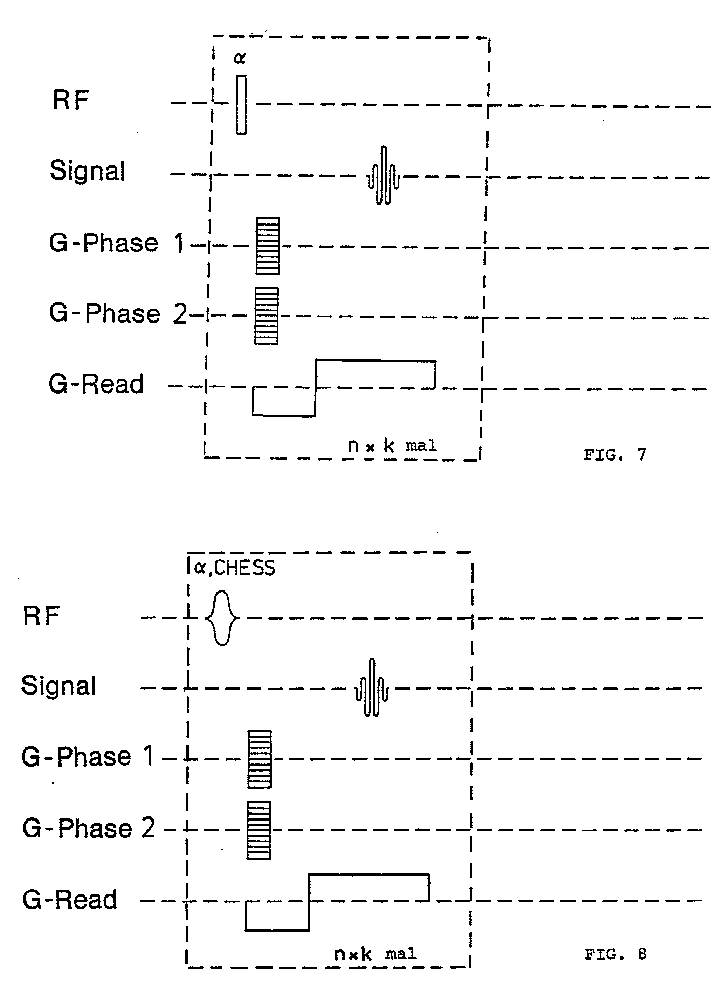

(13) Die Möglichkeit der Akquisition von Daten für dreidimensionale Darstellungen von lebenden Systemen (siehe die folgende Beschreibung der Figuren 7 und 8), wobei der Hauptvorteil gegenüber herkömmlichen 3D-NMR-Verfahren die erheblich reduzierte Meßzeit ist, z. B. 4 Minuten für eine 128x128x128-Pixel-Bildaufnahme. Das günstige Signal/Rausch-Verhältnis pro Zeiteinheit der Sequenzen ermöglicht die Erzeugung besonders dünner Schichten (1 mm und darunter). Die Kontraste der Bilder können gemäß (9) variiert werden. Es besteht insbesondere die Möglichkeit für eine

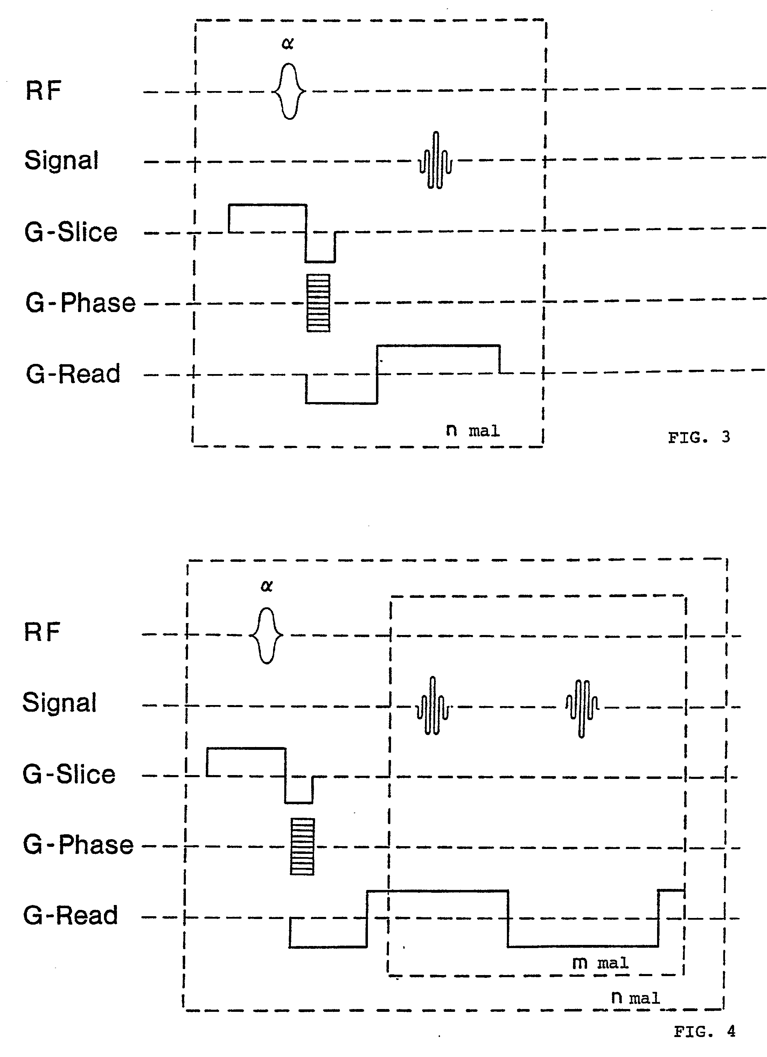

- isotrope 3D-Datenerfassung mit der Möglichkeit zur Rekonstruktion von Bildern beliebiger Orientierung (s. Fig. 7),
- chemisch selektive Bildgebung der oben beschriebenen Art (s. Fig. 8),
- Mehrecho-3D-Bildgebung der oben beschriebenen Art bei Verwendung mehrerer Gradientenechos (analog zu Fig. 4),
- Ausschnitt oder Zoom-3D-Bildgebung bei Verwendung eines schichtselektiven Pulses in einer und/oder zwei Richtungen der Phasencodierung zur Begrenzung des abgebildeten Volumens,
- mikroskopische 3D-Bildgebung an kleinen Proben mit dünnsten Schichten.

(14) Die Möglichkeit bildgebender Untersuchungen an lebenden Systemen in Kombination mit Oberflächenspulen, insbesondere

- Verwendung einer homogenen Sendespule und einer Oberflächenspule zum Empfang bei allen im folgenden beschriebenen Verfahren, und
- Verwendung einer Oberflächenspule zum Senden und Empfangen für alle im folgenden beschriebenen Verfahren.

(15) Die Möglichkeit der Daten-Akquisition für eine bildgebende Untersuchung von Fließvorgängen und Gefäßen mit NMR-Tomogrammen im Sekundenbereich, insbesondere

- Darstellung von Gefäßen, die senkrecht zur Schichtebene verlaufen, z. B. mit Verfahren gemäß (9) mit Variation des Flipwinkels und/oder der Auslesezeit des Gradienten-Echos und/oder Stärke des Lesegradienten,
- Mehrschichtaufnahmen nach obiger Art im zeitlichen Abstand von 1-3T$_1$ zur dreidimensionalen Rekonstruktion von Gefäßen.

Für den Fachmann und Mediziner werden sich noch eine Vielzahl anderer offensichtlicher Anwendungsmöglichkeiten ergeben, auf die hier aus Raumgründen nicht näher eingegangen werden soll.

Das sogenannte "Echo-Planar-Imaging"-Verfahren hat u. a. nicht die unter (2), (3) und (4) genannten Vorteile des erfindungsgemäßen Verfahrens. Es kann jedoch in ein Verfahren gemäß der vorliegenden Erfindung als Teil-Experiment integriert werden, falls die Voraussetzungen für eine schnelle Schaltung von Magnetfeldgradienten (d.h. schnell im Vergleich zu T$_2$*) gegeben sind. Das Verfahren gemäß der oben bereits genannten älteren europäischen Patentanmeldung Nr. 85115818 hat nicht die unter (2) genannten Vorteile der vorliegenden Erfindung.

Im folgenden werden bevorzugt Ausführungsbeispiele der Erfindung unter Bezugnahme auf die Abbildungen näher erläutert.

Fig. 1 und 2 sind Teilexperiment-Diagramme für Ausführungsformen des vorliegenden Verfahrens, die Daten für Durchleuchtungstomogramme (ohne Schichtauswahl) liefern;

Fig. 3 bis 6 sind entsprechende Diagramme für Ausführungsformen des vorliegenden Verfahrens, die Daten für Schicht-Tomogramme liefern;

Fig. 7 und 8 sind entsprechende Diagramme für Ausführungsformen des vorliegenden Verfahrens, die Daten für dreidimensionale Tomogramme liefern;

Fig. 9 ist ein entsprechendes Diagramm für Ausführungsformen des vorliegenden Verfahrens, die Daten für Tomogramme nach der Projektions-Rekonstruktions-Methode liefern.

Fig. 10, 11, und 12 zeigen Diagramme spezieller, vorteilhafter Ausführungsformen der Erfindung,

Fig. 13 zeigt eine Serie von Aufnahmen, die mit dem Verfahren gemäß Fig. 10 hergestellt wurde,

Fig. 14 und 15 zeigen zwei Serien von Aufnahmen, die mit dem Verfahren gemäß Fig. 12 hergestellt wurden;

Fig. 16 zeigt eine schematische Darstellung eines NMR-Gerätes, das zur Durchführung der erfindungsgemäßen Verfahren verwendet werden kann.

Die Diagramme zeigen in idealisierter, schematischer Darstellung Hochfrequenzpulse (RF), Gradientenfelder (Schichtgradient: "G-Slice", phasencodierender Gradient: "G-Phase" und Lesegradient; "G-Read") sowie zugehörige Meßsignale, d.h. Gradienten-Echos ("Signal") von Tomografie-Sequenzen, wobei jeweils die Anzahl der Wiederholungen von durch gestrichelte Kästen dargestellten Teil-Experimenten und/oder die Anzahl der Wiederholungen der Gesamt-Experimente angegeben ist. Die Darstellung des bzw. der phasencodierenden Gradienten ist so zu verstehen, daß sich die Amplitude des Gradientenpulses von Teil-Experiment zu Teil-Experiment ändert. Die Anzahl der Teil-Experimente entspricht daher der Anzahl unterschiedlicher Amplituden des phasencodierenden Gradienten. Hochfrequenzpulse mit rechteckig gezeichneten Hüllkurven stellen nicht-selektive Hochfrequenzpulse mit entsprechender Hüllkurve dar. Hochfrequenzpulse mit gaußförmig gezeichneten Hüllkurven stellen frequenz-selektive (d.h. CHESS = "chemical shift" -selektive), oder in Anwesenheit eines Gradienten schicht-selektive Hochfrequenzpulse mit wählbarer Hüllkurve dar.

Die vorliegenden Verfahren können mit bekannten Spinresonanzgeräten, insbesondere NMR-Geräten, durchgeführt werden, lediglich das Steuergerät, welches die Gradientenmagnetfelder und die anregenden Hochfrequenzpulse schaltet, wird so abgewandelt, daß es Funktionen entsprechend einer Ausführungsform oder wahlweise einer von mehreren Ausführungsformen des vorliegenden neuen Verfahrens auszuüben vermag.

Wie Fig. 16 schematisch zeigt, enthält ein übliches NMR-Gerät einen Meßkopf 10, einen Stromversorgungsteil 12 und einen Steuerteil 14. Der Meßkopf 10 des Gerätes kann, wie üblich, einen Magneten 16 zum Erzeugen eines konstanten, homogenen ("longitudinalen") $B_0$-Feldes enthalten, ferner Spulensätze 18, 20, 22 zum Erzeugen von drei im wesentlichen aufeinander senkrecht stehenden, im allgemeinen linearen Gradientenmagnetfeldern (von denen gewöhnlich eines parallel und die anderen beiden senkrecht zum $B_0$-Feld verlaufen) und eine Spulenanordnung 24, der die Hochfrequenzpulse zugeführt werden. Der Stromversorgungsteil enthält eine Stromversorgungseinheit 24 für den $B_0$-Magneten, eine Stromversorgungseinheit 28 für die Gradientenspulen 18, 20 und 22 und einen Hochfrequenzgenerator 30, der die Hochfrequenzimpulse für die HF-Spule 24 liefert. Der Steuerteil 14 steuert die Dauer und Amplitude der den jeweiligen Gradientenspulen zugeführten Ströme sowie die Dauer, Amplitude, Frequenz und Hüllkurve der Hochfrequenzpulse. Die HF-Spule 24 dient im allgemeinen auch zum Empfang der von der Probe abgestrahlten Signale. Der $B_0$-Magnet 16 kann supraleitende Magnetspulen enthalten und mit einem Kryostat versehen sein. Geräte dieser Art sind bekannt und im Handel erhältlich, so daß sich eine weitere Erläuterung erübrigt. Unter dem Begriff Hochfrequenzpuls soll sowohl ein Schwingungszug vorgegebener Frequenz mit beliebiger Hüllkurve, der, wenn er kurz ist und eine hohe Amplitude hat, als nicht-selektiver Puls bezeichnet wird, fallen, ferner ein frequenzmodulierter Hochfrequenz-Schwingungszug, weiterhin eine Folge voneinander beabstandeter, relativ kurzer Hochfrequenz-Schwingungszüge, die gleiche oder unterschiedliche Frequenzen aufweisen können und als Ganzes einen vorgegebenen Flipwinkel ergeben. Ein frequenz-selektiver Puls ist ein schichtselektiver Puls oder ein resonanzlinien-selektiver (CHESS = "chemical shift" - selektiver) Puls.

Bei dem vorliegenden Verfahren erfolgt die Anregung für die Signalerzeugung grundsätzlich mit einem Hochfrequenzpuls, dessen Flipwinkel nur einem Bruchteil des sonst üblichen Flipwinkels von 90 Grad entspricht. Die Teil-Experimente folgen unmittelbar aufeinander, ohne daß die sonst üblichen Wartezeiten in der Größenordnung der Spin-Gitter Relaxationszeit $T_1$ abgewartet zu werden brauchen. Die Länge der Teil-Experimente beträgt maximal nur etwa $3T_2^*$; die Länge des Gesamt-Experiments beträgt entsprechend maximal nur $3nT_2^*$, wenn n die Anzahl der Teil-Experimente ist.

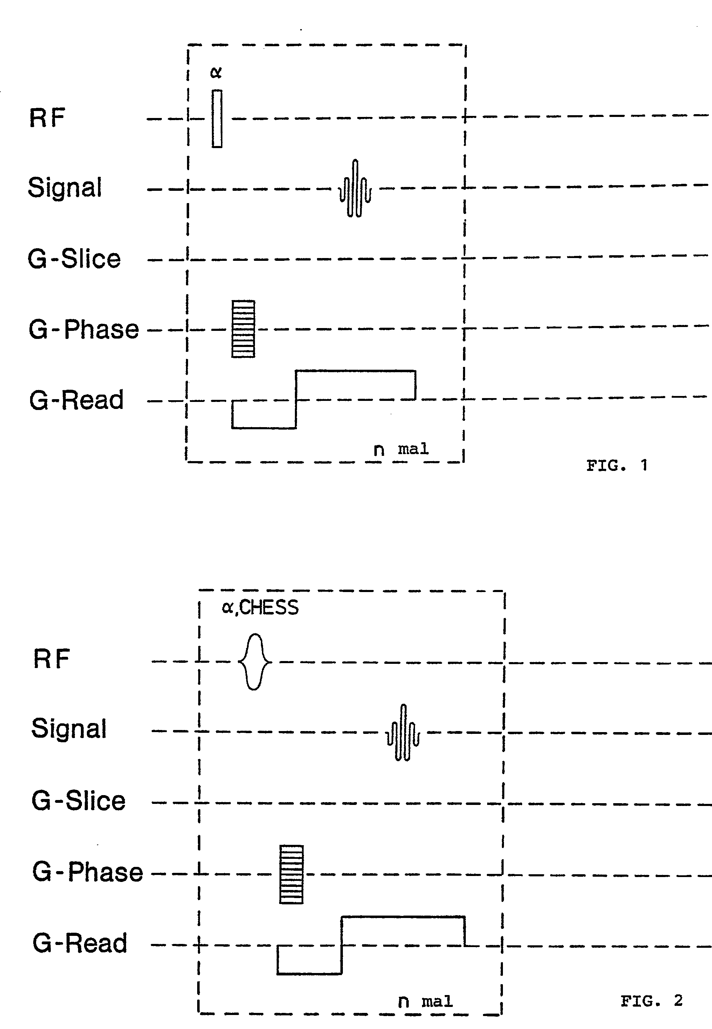

Fig. 1 zeigt den zeitlichen Verlauf und die Aufeinanderfolge der Hochfrequenzpulse RF, Signale (Gradienten-Echos) und Gradientenfelder für eine Ausführungsform des vorliegenden Verfahrens zur Gewinnung von NMR-Daten zum Erzeugen eines Durchleuchtungsbildes ohne Schichtauswahl. Das dargestellte Teil-Experiment wird ohne Verzögerung n-mal mit n verschiedenen Amplituden des phasencodierenden Gradienten wiederholt, d.h. daß sofort nach dem Abschalten des Lesegradienten G-Read der das nächste Teilexperiment einleitende Hochfrequenzpuls RF erzeugt wird. Der Flipwinkel $\alpha$ des nicht-selektiven HF-Pulses RF beträgt einen Bruchteil von 90° und liegt z. B. im Bereich von 10 bis 50°. Der Lesegradient wird zur Erzeugung eines Gradienten-Echosignals alterniert.

Der Gradienten-Puls G-Phase beginnt also nach Beendigung des HF-Pulses RF und endet vor der Datenaufnahme, also vor Beginn der Abtastung des Gradientenecho-Signals. Der Lesergradient G-Read wird nach Beendigung des HF-Pulses RF eingeschaltet, vor Beginn der Datenaufnahme zur Erzeugung des Gradienten-Echosignales polaritätsmäßig umgeschaltet und dann für die Dauer der Datenaufnahme konstant aufrechterhalten.

Zur Datenaufnahme wird das Gradientenecho-Signal unter Erzeugung einer Vielzahl (z. B. 128 oder 256) von kurzen Signalproben in Abständen von z. B. 20 Mikrosekunden abgetastet ("Sampling"). Die erhaltenen Signalproben werden dann demoduliert und in üblicher Weise zur Bild-Rekonstruktion mittels eines Computers verwendet.

Nach Beendigung der Datenaufnahme und Abschalten des Lesegradienten-Pulses G-Read des in dem gestrichelten Rechteck Dargestellten Teil-Experiments wird sofort, also mit dem kürzesten zeitlichen Abstand, den die Abschaltung des Lesegradienten erlaubt (und der wesentlich kleiner als $T_1$ und $T_2^*$ sein kann), der nächste HF-Puls RF zur Einwirkung gebracht und damit das nächste Teilexperiment begonnen. Dies gilt auch für die folgenden Ausführungsbeispiele. Eine Erholungszeit ist nicht erforderlich, da wegen des kleinen Flipwinkels noch genügend Spins, die in Z- oder $B_0$-Richtung ausgerichtet sind, für die Anregung durch den nächsten HF-Puls zur Verfügung stehen.

Bei allen Experimenten kann es zweckmäßig sein, die Datenaufnahme erst nach einigen "Leer"-Teilexperimenten zu beginnen. Vor der Datenaufnahme können z. B. 5 bis 50 Leer-Teilexperimente durchlaufen werden, die den Zweck haben, den jeweiligen Flipwinkel entsprechenden Gleichgewichtszustand der Z-Magnetisierung einzustellen und einen gleichmäßigen Informationsinhalt der Gradienten-Echos sicherzustellen. Leer-Teilexperimente können vermieden werden, wenn das Gesamtexperiment aus Teilexperimenten aufgebaut wird, deren Anregungspuls-Flipwinkel von kleinen Werten so ansteigen, daß stets im wesentlichen der gleiche Magnetisierungsanteil ausgelesen wird.

Fig. 2 zeigt den zeitlichen Verlauf der Hochfrequenzpulse RF, Meßsignale und Gradientenfelder für eine Ausführungsform des vorliegenden Verfahrens zur Gewinnung von NMR-Daten zum Erzeugen, eines resonanzlinien-selektiven (CHESS-) Durchleuchtungsbildes ohne Schichtauswahl.

Fig.3 zeigt den zeitlichen Verlauf der Hochfrequenzpulse, Meßsignale und Gradientenfelder für eine Ausführungsform des vorliegenden Verfahrens zur Gewinnung von NMR-Daten zum Erzeugen eines Schicht-Tomogramms.

Dazu wird der frequenz-selektive Hochfrequenzpuls RF mit einem Schichtgradienten G-Slice in bekannter Weise kombiniert.

Für diese schicht-selektive Variante des erfindungsgemäßen Verfahrens gilt, daß der Schichtgradient G-Slice vor Beginn des HF-Pulses eingeschaltet wird, nach Beendigung des HF-Pulses zur Refokussierung umgeschaltet wird und dann vor Beginn der Datenaufnahme abgeschaltet wird. Im übrigen gelten die in Verbindung mit Fig. 1 gemachten Ausführungen.

Fig. 4 zeigt den zeitlichen Verlauf der Hochfrequenzpulse, Meßsignale und Gradientenfelder für eine Ausführungsform des vorliegenden Verfahrens zur Gewinnung von NMR-Daten zum Erzeugen eines Schicht-Tomogramms, dessen Signal-zu-Rausch-Verhältnis und/oder dessen Kontraste durch die Verwendung einer Anzahl m von Echosignalen verbessert wird. Dazu wird der Lesegradient nach jedem HF-Puls m-mal alterniert. Die Daten aus jeweils m zusammengehörigen Echos werden einander überlagert bzw. gemittelt.

Fig. 5 zeigt den zeitlichen Verlauf der Hochfrequenzpulse, Meßsignale und Gradientenfelder für eine Ausführungsform des vorliegenden Verfahrens, bei dem die Daten für eine Anzahl k von Schicht-Tomogrammen der gleichen Schicht unmittelbar hintereinander erzeugt werden. Dazu wird das aus n Teil-Experimenten bestehende Gesamt-Experiment k-mal wiederholt und zwar ohne irgendwelche Relaxations- oder Erholungsintervalle zwischen den aufeinanderfolgenden Teil- oder Gesamtexperimenten. Dieses Verfahren ist ohne jede Alternative in der bildgebenden magnetischen Kernresonanz, da es ohne Verlust in der Signalstärke eine kontinuierliche Bildgebung ohne zeitliche Begrenzung ermöglicht. Es ist damit besonders vorteilhaft für die Untersuchung dynamischer Vorgänge. Die Dauer eines Teilexperiments kann z. B. nur etwa 15 ms betragen.

Fig. 6 zeigt den zeitlichen Verlauf der Hochfrequenzpulse, Meßsignale und Gradientenfelder für eine Ausführungsform des vorliegenden Verfahrens, bei dem die Daten für eine Anzahl k von Schicht-Tomogrammen aus verschiedenen Schichten unmittelbar hintereinander gewonnen werden.

Dazu wird die Trägerfrequenz des Hochfrequenzpulses aller Teil-Experimente von Gesamt-Experiment zu Gesamt-Experiment geändert. Dieses Experiment läßt sich mit dem in Fig. 5 gezeigten Verfahren kombinieren.

Fig. 7 zeigt den zeitlichen Verlauf von Hochfrequenzpulsen, Meßsignalen und Gradientenfeldern für eine Ausführungsform des vorliegenden Verfahrens zum Gewinnen der Daten für ein dreidimensionales Tomogramm. Dazu wird ein nicht-selektiver Hochfrequenzpuls verwendet und statt eines Schichtgradienten wird ein zweiter phasencodierender Gradient geschaltet mit einer Anzahl k von unterschiedlichen Amplituden. Beide Phasengradienten G-Phase 1 und G-Phase 2 werden nach Beendigung des HF-Pulses eingeschaltet und vor Beginn der Datenaufnahme, also vor dem Umschalten des Lesegradienten G-Read abgeschaltet. Das Gesamt-Experiment setzt sich in diesem Fall aus n x k Teil-Experimenten zusammen. Dieses Verfahren ist besonders vorteilhaft, da es eine dreidimensional anisotrope (k n) oder isotrope (k = n) räumliche Darstellung des Untersuchungsobjektes in etwa derjenigen Meßzeit gestattet, die mit konventionellen Spin-Echo-Tomografie-Verfahren für ein nur zweidimensionales Schnittbild benötigt wird. Das Verfahren kann zur Darstellung extrem dünner Schichten ausgenützt werden.

Fig. 8 zeigt den zeitlichen Verlauf von Hochfrequenzpulsen, Meßsignalen und Gradientenfeldern für eine Ausführungsform des vorliegenden Verfahrens zur Gewinnung der Daten für ein dreidimensionales frequenzselektives (CHESS-) Tomogramm analog zu Fig. 7. Dazu wird der nicht-selektive Hochfrequenzpuls der Teil-Experimente durch einen frequenz-selektiven Puls ersetzt.

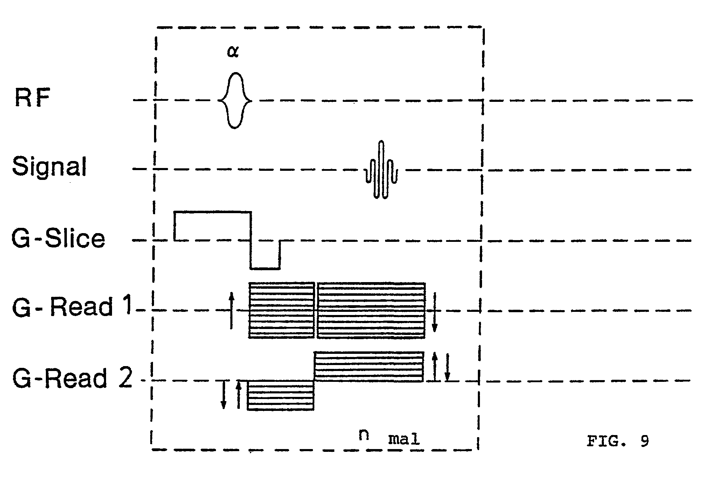

Fig. 9 zeigt den zeitlichen Verlauf der Hochfrequenzpulse, Meßsignale und Gradientenfelder für eine Ausführungsform des vorliegenden Verfahrens zur Gewinnung der Daten für ein Schicht-Tomogram nach dem Projektions-Rekonstruktions-Verfahren. Dazu wird der phasencodierende Gradient durch einen zweiten Lesegradienten ersetzt, der synchron mit dem ersten Lesegradienten geschaltet wird. Die Amplituden der beiden Lesegradienten variieren dabei von Teil-Experiment zu Teilexperiment in der durch die Pfeilrichtungen angegebenen Weise. Sie ergänzen sich zu einem resultierenden Lesegradienten, dessen Orientierung in der Schichtebene von Teil-Experiment zu Teil-Experiment rotiert. Auch die Ausführungsformen nach Fig. 1 bis 8 können in entsprechender Weise vom Fourier-Verfahren (mit einem phasencodierenden Gradienten) auf das Projektions-Rekonstruktions-Verfahren (mit alleiniger Frequenzcodierung) übertragen werden.

Es folgen praktische Ausführungsbeispiele des vorliegenden Verfahrens. Als NMR-Gerät wurde ein im Handel erhältliches NMR-Tomographie/Spektroskopie System der Fa. Bruker, Karlsruhe (Bundesrepublik Deutschland) verwendet, das einen $B_0$-Magneten mit der Feldstärke 2,3 Tesla (T), entsprechend einer Protonenresonanzfrequenz von 100 MHz, und mit einer Bohrung von 40 cm Durchmesser enthält.

BEISPIEL 1:

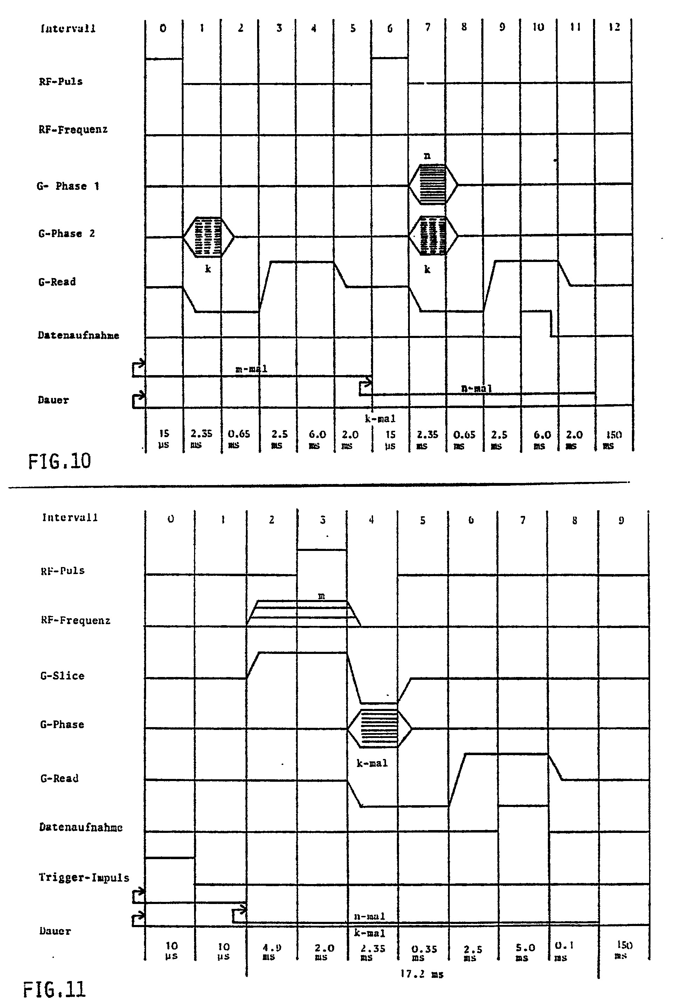

Schnelle dreidimensionale Bildaufnahme Pulssequenz gemäß Fig. 10 (analog zu Fig. 7)

Intervall Bemerkungen

0 Schaltung eines nicht-selektiven HF-Pulses mit z. B. rechteckiger Hüllkurve. Die Sendeleistung des HF-Senders wird so gewählt, daß der HF-Puls einen Flipwinkel von etwa 30 Grad erzeugt. Die Länge des nicht-selektiven Pulses ist 15 Mikrosekunden bei Verwendung eines Resonators mit dem Durchmesser von 20 cm und einer Sendeleistung von ca. 5 KW. Die Phasenlage des Pulses bleibt konstant. Die HF-Frequenz wird auf die Resonanzfrequenz der Wasser-Protonen (100 MHz bei 2,3 Tesla) eingestellt.

1 Anschalten des Lesegradienten zur Vorbereitung des im Intervall 3 und 4 eingeschalteten Lesegradienten; Amplitude -5,5, mT/m. Anschalten des Phasengradienten 2.

2 Der Lesegradient bleibt angeschaltet; Anschalten des Phasengradienten 2.

3 Umschalten des Lesegradienten. Amplitude +4,5 mT/m.

4 Der Lesegradient bleibt angeschaltet.

5 Abschalten des Lesegradienten. Nach dem Ende dieses ersten Vorbereitungs-Intervalls, bei dem keine Datenerfassung stattfindet, beginnt das Programm bei Intervall 0 von Neuem.

Die Vorbereitungssequenz 0 bis 5 wird m-mal (m=8) durchlaufen. Dadurch erreicht das Spinsystem einen konstanten Gleichgewichtszustand. Die Vorbereitungssequenzen dienen außerdem zur Durchführung von "vorbereitenden" Schaltoperationen des Spulensystems der Magnetfeldgradienten, die bei dem hier verwendeten NMR-Gerät aus technischen Gründen erforderlich sind.

6 Anschalten des HF-Impulses. Dieser Puls hat in Bezug auf die Frequenz, Amplitude, Länge und Form die gleichen Eigenschaften wie der HF-Puls im Intervall 0.

7 Anschalten des Phasengradienten 1. Anschalten des Lesegradienten zur Vorbereitung des in den Intervallen 9 und 10 geschalteten Lesegradienten; Amplitude -5,5 mT/m; Anschalten des Phasengradienten 2.

8 Abschalten der Phasengradienten 1 und 2. Der Lesegradient bleibt angeschaltet.

9 Umschalten des Lesegradienten auf die Amplitude +4,5 mT/m.

10 Der Lesegradient bleibt angeschaltet. Aufnahme von je 128 "realen" und "imaginären" Daten durch Abtasten des durch das Umschalten des Lesegradienten erzeugten Gradienten-Echosignals und Quadraturdetektion der Proben mit der spektralen Weite von 25 kHz (Abtastperiode 20 Mikrosekunden entsprechend 50 kHz Sampling-Rate).

11 Abschalten des Lesegradienten. Beendigung der Datenaufnahme.

6a bis 11a: (n-1)-maliges Wiederholung der Sequenz 6 bis 11, so daß sie mit n verschiedenen Amplituden (hier n=128) des Phasengradienten 1 von -5,0 bis +5,0 mT/m, also insgesamt 128-mal durchlaufen wird. Der Phasengradient 2 hat beim n-maligen Durchlaufen der Sequenz 6 bis 11 jeweils die gleiche Amplitude.

12 Speicherung der n Datensätze. Dieser Prozeß ist im verwendeten System technisch bedingt, da der verfügbare Kernspeicher des Computers auf 128K begrenzt ist, er dauert etwa 150 Millisekunden. Die Unterbrechung erfordert eine Neueinstellung des in den Intervallen 0 bis 5 eingestellten Gleichgewichtszustandes. Die Sequenz springt deshalb auf 0 zurück.

In optimierten Systemen werden aufgenommene Daten direkt weiterverarbeitet. Damit entfällt Intervall 12 und die Sequenz kann auf Intervall 6 zurückspringen.

12a (k-1)maliges Wiederholen der Gesamtsequenz 0 bis 12, so daß die Sequenz 0 bis 12 insgesamt k-mal mit k verschiedenen Amplituden (hier k=128) des Phasengradienten 2 von -5,0 bis +5,0 mT/m 128-mal durchlaufen wird.

In optimierten Systemen hat die Gesamtsequenz eine Dauer von insgesamt n x k x (Dauer des Intervalls 6-11) = 221 Sekunden. Hier beträgt die Dauer ((n+m)x(Intervall 6-11) + Intervall 12) x k = 254 Sekunden.

Die Schichtdicke von zweidimensionalen Einzelbildern beträgt 1 mm, die Bildauflösung (Pixelgröße) beträgt 1 mm x 1 mm.

BEISPIEL 2:

Aufnahme eines Films bestehend aus einer Serie von schnellen Tomogrammen zur Darstellung von periodischen Bewegungen aus m Schichten

Pulssequenz gemäß Fig. 11 (analog Fig. 6)

Intervall Bemerkungen

0/1 Warteschleife für einen Triggerimpuls. Nach dem Empfang eines Triggerimpulses beginnt die Sequenz mit Intervall 2.

2 Anschalten des Schichtgradienten. Amplitude +5,0 mT/m. Die HF-Frequenz wird auf die Resonanz-Frequenz der gewünschten Kerne, z.b. der Wasserprotonen, in der gewünschten Schicht eingestellt.

3 Anschalten des frequenz-selektiven HF-Pulses mit gaußförmiger Hüllkurve. Der HF-Puls hat einen Flipwinkel von etwa 30 Grad. Die Halbwertsbreite des Frequenzspektrums des Pulses beträgt ca. 900 Hz. Die Phasenlage des Pulses ist konstant während des Gesamtexperimentes.

4 Umschalten des Schichtgradienten. Amplitude -5,0 mT/m. Anschalten des Lesegradienten zur Vorbereitung des Lesegradienten in Intervall 6 und 7. Amplitude -5,5 mT/m. Anschalten des Phasengradienten. Dieser Vorgang wird bei n-maligem Durchlaufen der Sequenz 2 bis 9 mit gleicher Amplitude wiederholt (hier n=32). Bei k-maligem Wiederholen der Gesamtsequenz 0 bis 9 wird der Phasengradient mit k verschiedenen Amplituden (hier k=128) von -5,0 mT/m bis +5,0 mT/m 128-mal durchlaufen.

5 Abschalten des Schichtgradienten. Abschalten des Phasengradienten. Der Lesegradient bleibt angeschaltet.

6 Umschalten des Lesegradienten. Amplitude +4,5 mT/m.

7 Der Lesegradient bleibt angeschaltet. Aufnahme von je 128 "realen" und "imaginären" Datenpunkten durch Abtasten des Echosignales und Quadraturdetektion der erhaltenen Proben mit der spektralen Weite von 25 kHz (Abtastperiode 20 Mikrosekunden).

8 Abschalten des Lesegradienten; Beendigung der Datenaufnahme.

Die Sequenz springt n-mal auf Intervall 2 zurück. Im Intervall 2 können beim aufeinanderfolgenden Durchlaufen der Sequenz 2 bis 9 eine Anzahl m verschiedener HF-Frequenzen entsprechend m verschiedenen Schichten eingestellt werden. Das Anschalten des Phasengradienten im Intervall 4 wird bei n-maligem Durchlaufen der Sequenz 2 bis 9 mit gleicher Amplitude wiederholt (hier n=32). Bei k-maligem Wiederholen der Gesamtsequenz 0 bis 9 wird der Phasengradient mit k verschiedenen Amplituden (hier z. B. k = 128) von -5,0 mT/m bis +5,0 mT/m 128-mal durchlaufen.

9 Abspeicherung der n Datensätze. Dieser Prozeß ist im verwendeten System technisch bedingt, da der Kernspeicher des Computers begrenzt ist, er benötigt 150 Millisekunden. Danach springt die Sequenz auf das Intervall 0 zur Warteschleife für einen neuen Triggerimpuls zurück. Dieser Vorgang wird m-mal durchgeführt.

Die Sequenz erlaubt die Aufnahme von n (hier z. B. n = 32) schnellen Tomogrammen (128x128 Bildpunkte, entsprechend k=128), die im unmittelbaren zeitlichen Abstand nach einem Triggerimpuls aufgenommen werden. Das erste Bild entsteht 7 Millisekunden nach dem Triggerimpuls, jedes weitere Bild folgt dem letzten im Abstand von 17,2 Millisekunden.
Für Gating-Experimente läuft das Gesamtexperiment ohne Warteschleife 0/1 ab. Der Triggerimpuls in Intervall 0 dient dann zum Weiterschalten des Phasengradienten mit k verschiedenen Amplituden.
Für Untersuchungen am Menschen eignet sich die Sequenz insbesondere für EKG-getriggerte (oder gegatete) Bildgebung am Herzen. In diesem Fall kann mit n=50 in ca. 850 Millisekunden der gesamte Herzzyklus abgetastet und aus z. B. 128 oder 256 solcher Abtastungen können dann 50 Bilder aus einer Schicht oder 50/m Bildern aus m Schichten rechnerisch rekonstruiert werden.

BEISPIEL 3:

Aufnahme der Daten für einen Film bestehend aus einer Serie von schnellen Tomogrammen zur Beobachtung von Bewegungen, Funktionen und Bildern in Realzeit aus l Schichten

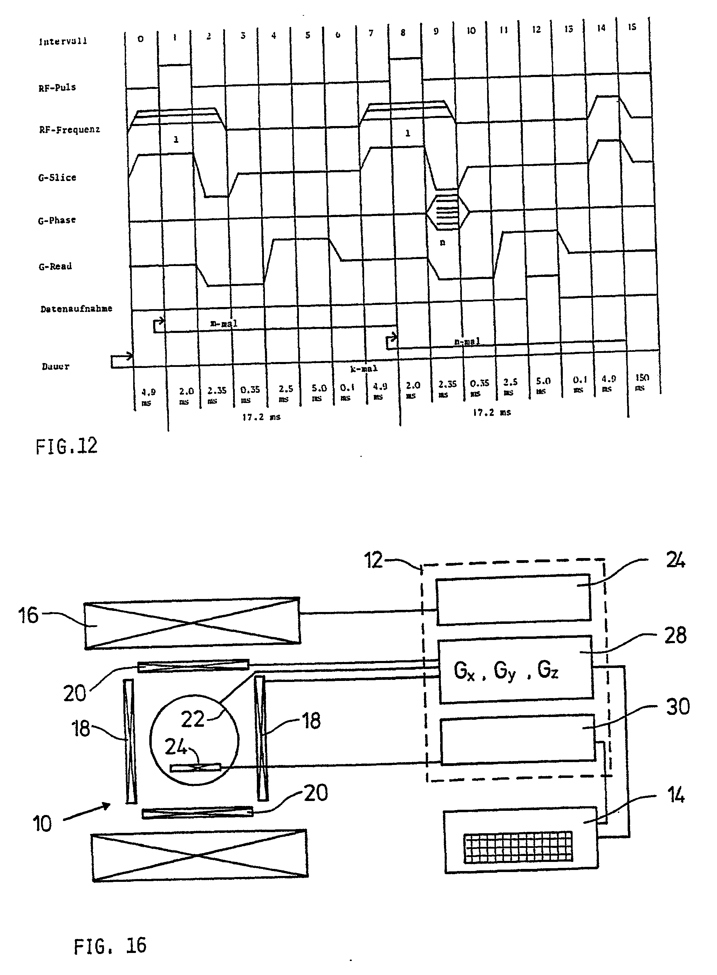

Pulssequenz gemäß Fig. 12

Intervall Bemerkungen

0 Anschalten des Schichtgradienten; Amplitude +5,0 mT/m. Einstellen der HF-Frequenz auf die gewünschte Beobachtungsschicht. Die Frequenz kann bei k-maligem Durchlaufen der Sequenz beliebig variiert werden, um l verschiedene Beobachtungsschichten zu erhalten. (l=1 für Einzelschicht - Filme, l=k für MehrschichtFilme).
1. Der Schichtgradient bleibt angeschaltet. Schaltung des frequenz-selektiven HF-Impulses mit gaußförmiger Hüllkurve. Der HF-Impuls hat einen Flipwinkel von ca. 30 Grad. Die Halbwertsbreite des Frequenzspektrums des Pulses beträgt ca. 900 Hz. Die Phasenlage des Pulses ist konstant während des Gesamtexperimentes.
2 Abschalten des HF-Impulses. Einstellen der HF-Frequenz auf die Beobachtungsfrequenz, die zum Beispiel die Resonanzfrequenz der Wasserprotonen sein kann. Umschalten des Schichtgradienten; Amplitude -5,0 mT/m. Anschalten des Lesegradienten zur Vorbereitung des Lesegradienten in Intervall 4,5. Amplitude -5,5 mT/m.
3. Abschalten des Schichtgradienten.
Der Lesegradient bleibt angeschaltet.
4. Umschalten des Lesegradienten. Amplitude +4,5 mT/m.
5. Der Lesegradient bleibt angeschaltet.
6. Abschalten des Lesegradienten.
7. Anschalten des Schichtgradienten; Amplitude 5,0 mT/m. Einstellen der HF-Frequenz auf die gewünschte Beobachtungsschicht. Diese Frequenz kann bei k-maligem Durchlaufen der Sequenz beliebig variiert werden, um l verschiedene Beobachtungsschichten zu erhalten (siehe Intervall 0).

Das Programm beginnt bei Intervall 1 m-mal von neuem. Die Sequenz 1 bis 7 wird m-mal (m=32) durchlaufen. Dadurch erreicht das Spinsystem einen konstanten Gleichgewichtszustand und es werden die für das Spulensystem der Magnetfeldgradienten des hier verwendeten Systems aus technischen Gründen benötigten "vorbereitenden" Schaltungen durchgeführt.

8. Der Schichtgradient bleibt angeschaltet Anschalten des frequenz-selektiven HF-Impulses mit gaußförmiger Hüllkurve. Der HF-Impuls hat einen Flipwinkel von 30 Grad. Die Halbwertsbreite des Frequenzspektrums des Pulses beträgt ca. 900 Hz. Die Phasenlage des Pulses ist konstant während des Gesamtexperimentes.
9. Abschalten des HF-Impulses. Einstellen der HF-Frequenz auf die Beobachtungsfrequenz, die zum Beispiel die Frequenz der Wasserprotonen sein kann. Umschalten des Schichtgradienten; Amplitude -5,0 mT/m. Anschalten des Lesegradienten zur Vorbereitung des Lesegradienten in den Intervallen 11 und 12; Amplitude -5,5 mT/m. Anschalten des Phasengradienten. Dieser Vorgang wird bei Wiederholung der Sequenz 7 bis 13 mit n verschiedenen Amplituden (hier n=128) von -5,0 mT/m bis +5,0 mT/m insgesamt 128-mal durchgeführt.
10. Abschalten des Schichtgradienten.
Abschalten des Phasengradienten.
Der Lesegradient bleibt angeschaltet.
11. Umschalten des Lesegradienten; Amplitude +4,5 mT/m.
12. Der Lesegradient bleibt angeschaltet. Aufnahme von je 128 "realen" und "imaginären" Daten bei Quadraturdektion mit der spektralen Weite von 25 kHz (Abtastperiode 20 Mikrosekunden).
13. Abschalten des Lesegraditnten; Beendigung der Datenaufnahme.
14. Anschalten des Schichtgradienten, Amplitude 5,0 mT/m. Einstellen der HF-Frequenz auf die gewünschte Beobach-tungsschicht. Die HF-Frequenz wird bei k-maligem Durchlaufen der Sequenz entsprechend Intervall 0 verändert.

Die Sequenz springt n-mal 8 zurück.

15. Abspeichern der n Datensätze.

Der Verfahrensschritt 15 benötigt etwa 150 Millisekunden und ist im verwendeten System technisch bedingt, da der Kernspeicher des Computers begrenzt ist. Die Unterbrechung erfordert eine Neueinstellung des in den Intervallen 1 bis 7 eingestellten Gleichgewichtszustandes. Die Sequenz springt deshalb n-mal auf Intervall 0 zurück um n Bilder aufzunehmen. In optimierten Systemen werden aufgenommene Daten direkt weiterverarbeitet. Damit entfällt Intervall 15 und die Sequenz kann sofort mit Intervall 8 fortgesetzt werden.

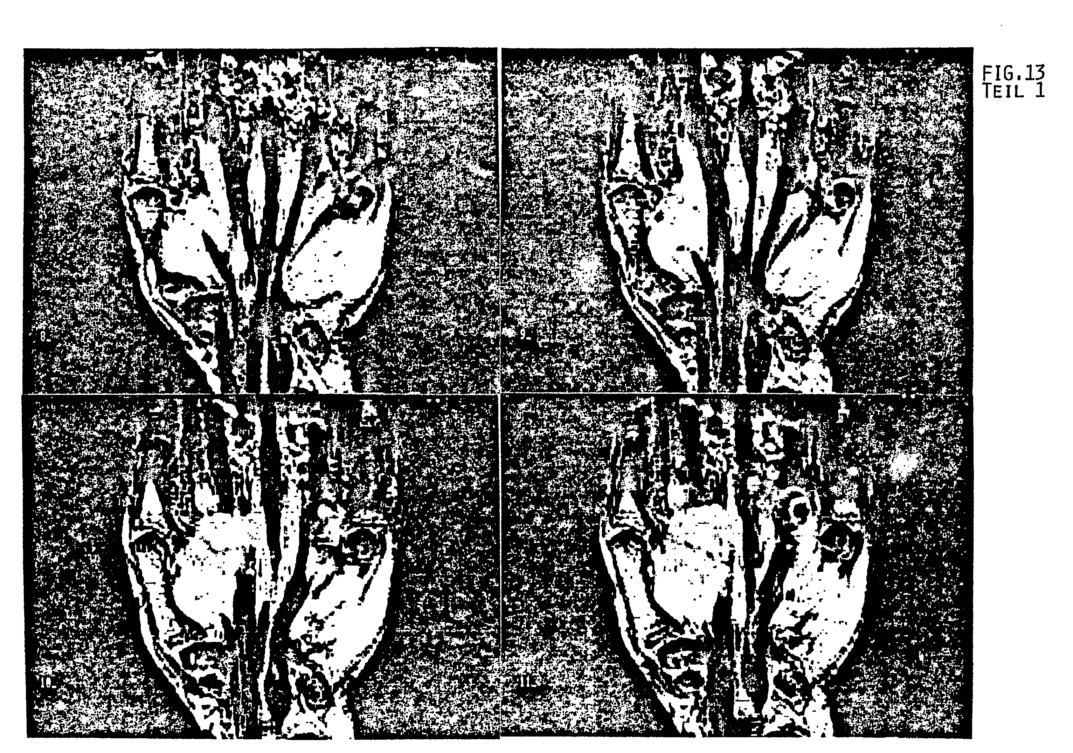

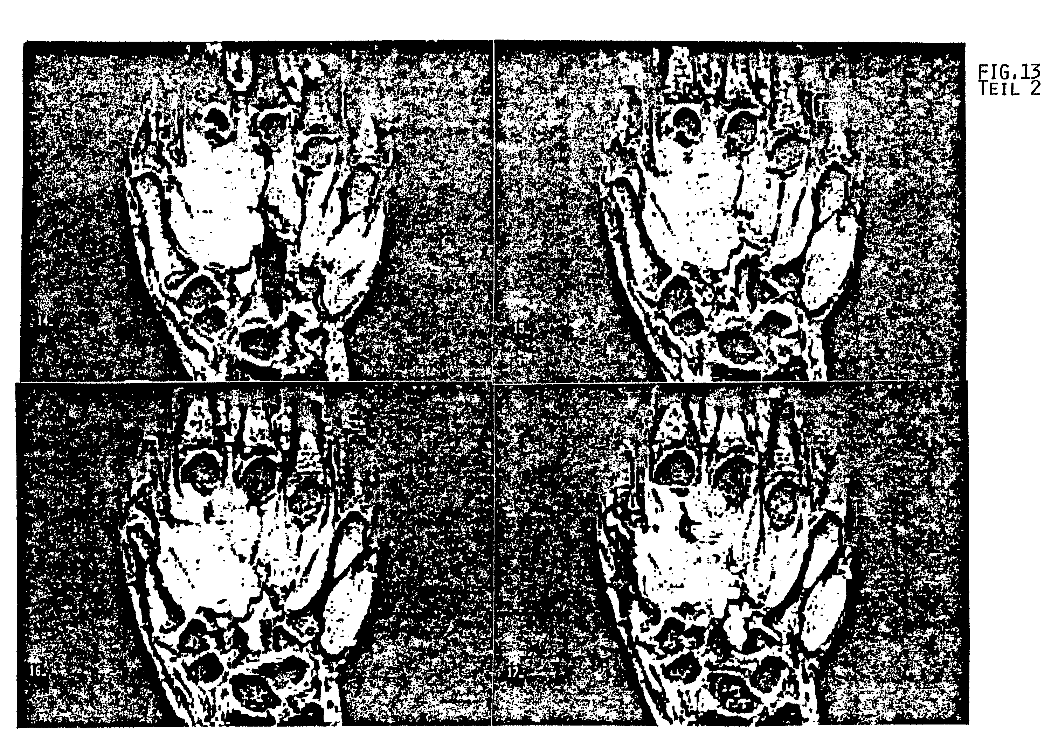

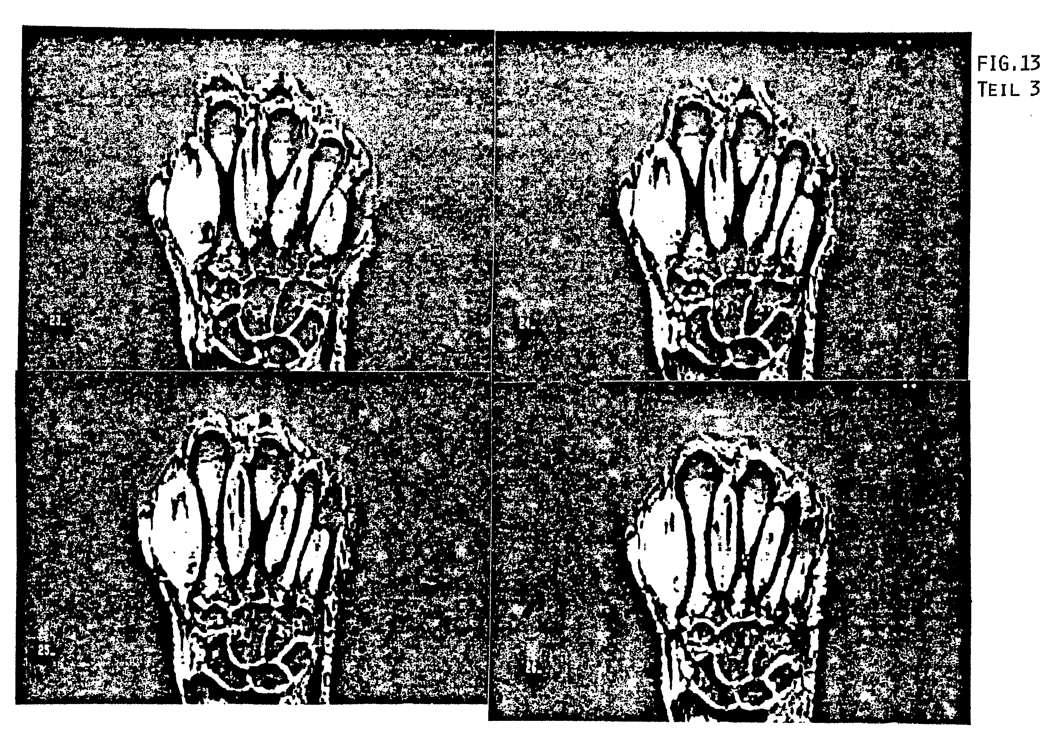

Fig.13 zeigt ausgewählte Bilder aus einer Serie von Aufnahmen der menschlichen Hand, welche aus den Daten rekonstruiert wurden, die mit dem schnellen dreidimensionalen Bildaufnahmeverfahren gemäß BEISPIEL 1 und Fig.10 gewonnen wurden. Die Gesamt-Meßzeit betrug 4 Minuten, die räumliche Auflösung ist 128x128x128 Pixel entsprechend 1 mm x 1 mm x 1mm. Dargestellt sind horizontale Schnittbilder im Bereich der Sehnen (Bilder Nr.8 bis 11), der Muskeln und Gelenkspalte (Bilder Nr. 14 bis 17) sowie der Mittelhandknochen (Bilder Nr. 23 bis 26).

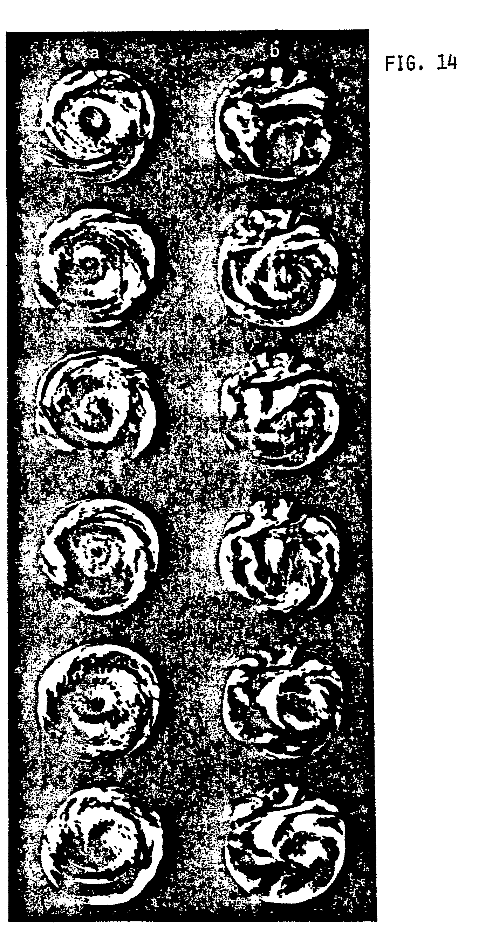

Fig.14 zeigt eine Sequenz von NMR-Tomogrammen, die durch das Verfahren gemäß Beispiel 3 und Fig. 12 gemessen worden sind. Es sind die Strömungsverhältnisse in einer horizontalen Schicht in einem Wassertopf nach dem Umrühren in zeitlichen Abständen von jeweils 1,3 Sekunden dargestellt und zwar in der mit (a) bezeichneten linken Spalte die ungestörten Strömungsverhältnisse nach Beendigung des Rührens und in der mit (b) bezeichneten rechten Spalte die Strömungsverhältnisse unmittelbar nach dem Eichführen eines Hindernisses am oberen Bildrand. Die Meßzeit pro Einzelbild betrug 1,15 Sekunden, die räumliche Auflösung 64x128 Pixel, die Schichtdicke 4 mm.

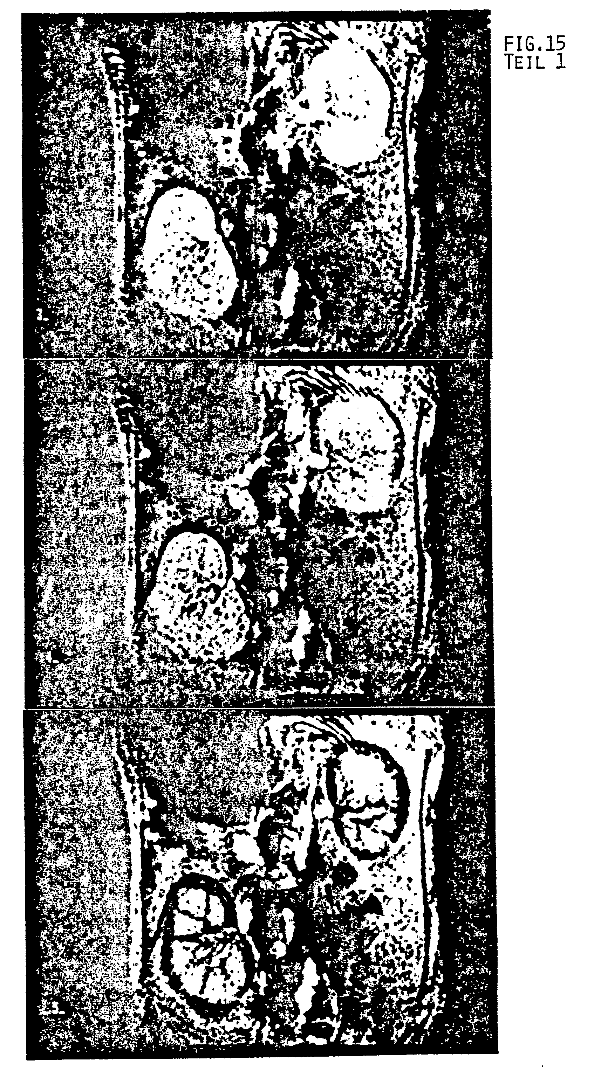

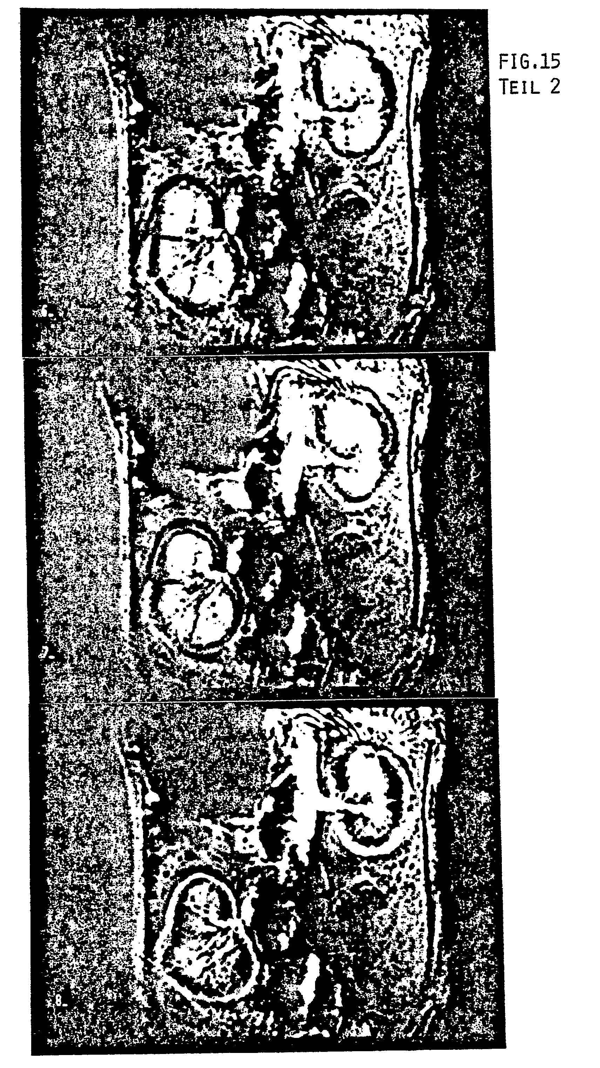

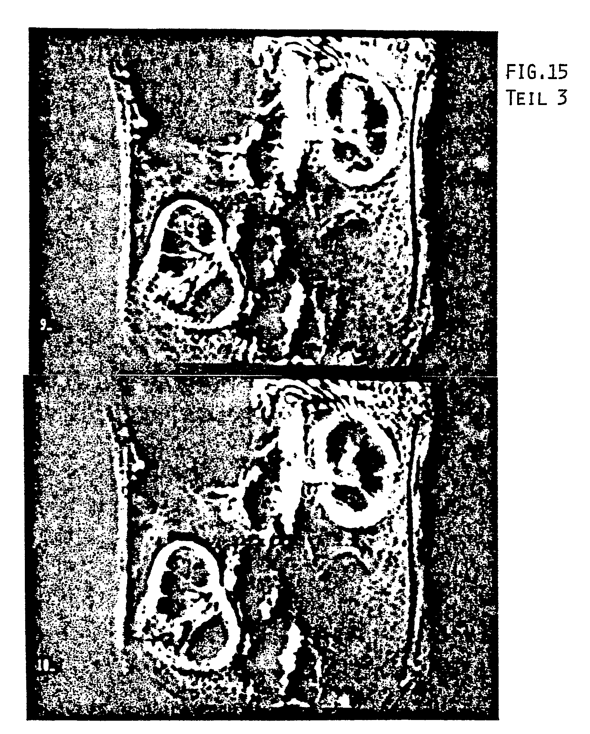

Fig.15 zeigt ausgewählte Bilder einer Sequenz von NMR-Tomogrammen mit einem zeitlichen Abstand von 6 Sekunden zwischen zwei aufeinanderfolgenden Bildern. Dargestellt ist die Nierenfunktion eines Kaninchens nach Verabreichung von 0,25 mmol/kg Gd (DTPA). Die linke Niere enthält einen Tumor. Die Meßzeit der Einzelbilder betrug 2,2 Sekunden, es wurden jeweils zwei Aufnahmen gemittelt, die räumliche Auflösung ist 128x128 Pixel und Schichtdicke 4 mm.

Die oben erläuterten Ausführungsbeispiele lassen sich in der verschiedensten Weise abwandeln und anwenden. Es war bereits erwähnt worden, daß der $T_1$-Kontrast durch Variation des Flipwinkels der HF-Pulse beeinflußt werden kann. Durch Variation der Auslesezeit der Gradienten-Echos kann der $T_2^*$-Kontrast beeinflußt werden.

Eine weitere Möglichkeit der Kontrastbeeinflussung besteht darin, an einer oder einigen wenigen Stellen, z.B. zwischen der Vorbereitungssequenz zur Gleichgewichseinstellung, während derer keine Datanaufnahme erfolgt, und der eigentlichen Meßsequenz oder jeweils nach der Messung von 16 oder 32 Teilprojektionen einen "Sonder"-HF-Puls zur Einwirkung zu bringen, bei dem es sich beispielweise um einen 90° -Puls, einen 180°-Puls oder einen CHESS-Puls handeln kann. Die Anzahl dieser zusätzlichen "Sonder"-HF-Pulse beträgt vorzugsweise nicht mehr als etwa 10% der Anzahl der Teilexperimente des Gesamtexperiments bzw. des gesamten Meßzyklus. In entsprechender Weise können durch Anwendung zusätzlicher frequenzselektiver HF-Pulse mit Flipwinkeln von 90° in Abwesenheit eines Gradienten vor und/oder an im Vergleich zur Anzahl der Bruchteils-HF-Pulse wenigen, ausgewählten Stellen während eines Gesamt-Experiments Daten für "chemical-shift"-gewichtete Tomogramme erhalten werden.

Durch die Anwendung zusätzlicher HF-Pulse und/oder HF-Pulspakete, die auf die Magnetisierungen außerhalb der Schichtebene des gewünschten Tomogramms wirken und vor und/oder an ausgewählten Stellen während des Gesamtexperiments zur Einwirkung gebracht werden, können unerwünschte Strömungseffekte ("reflow"-Phänomene) unterdrückt werden. Beispielsweise kann dadurch vermieden werden, daß fließendes Blut, das in die gemessene Schicht einströmt, übermäßig hell dargestellt wird. Man kann hier beispielsweise einen sog. DANTE-Pulszug (Sequenz von nicht-selektiven HF-Pulsen, deren Abstände so gewählt sind, daß sich eine gewünschtes Frequenzspektrum ergibt) oder einen selektiven Puls mit einem geeigneten Profil (Oberwellengehalt) verwenden, um alle Spins außerhalb der interessierenden Schicht so zu sättigen, daß sie, auch wenn sie in die gemessene Schicht einströmen, nicht zum Bild beitragen können.

Eine besonders zweckmäßige Zusatz-Pulsfolge besteht aus einem schicht-selektiven 45°-HF-Puls in (-x')-Richtung des rotierenden Koordinaten systems, einem nicht-selektiven 90°-HF-Puls in (+x')-Richtung und einem schicht-selektiven 45°-HF-Puls in (-x')-Richtung.

Bei einem Experiment mit von Teilexperiment zu Teilexperiment ansteigenden Flipwinkeln, das keine Leer-Teilexperimente zur Einstellung des Gleichgewichtszustandes erfordert und sich besonders zur Gewinnung von Daten für ein Mehrschicht-Tomogramm eignet, können z. B. für $T_1/TR$ = 40 (TR = Repetitionszeit der Teilexperimente) die folgenden Flipwinkel verwendet werden:

| Teilexperiment Nr. | Flipwinkel (Grad) |
| --- | --- |
| 1 | 7,5 |
| 10 | 8,1 |
| 20 | 8,7 |
| 30 | 9,4 |
| 40 | 10,0 |
| 50 | 10,7 |
| 60 | 11,5 |
| 70 | 12,2 |
| 80 | 13,2 |
| 80 | 14,2 |
| 100 | 15,6 |
| 110 | 17,4 |
| 120 | 20,5 |
| 130 | 28,1 |

Die in der obigen Beschreibung angegebenen Werte sind selbstverständlich nur Beispiele und im allgemeinen nur als Angabe der in Betracht kommenden Größenordnung zu verstehen.

**Patentansprüche**

1. Verfahren zum Betrieb eines Spinresonanzgerätes zur schnellen Aquisition von Spinresonanzdaten für eine ortsaufgelöste Untersuchung eines Bereiches eines Objekts, der atomare Spins enthält, die eine vorgegebene Spin-Gitterrelaxationszeit $T_1$, eine vorgegebene Spin-Spin-Relaxationszeit $T_2$ und eine vorgegebene effektive Spin-Spin-Relaxationszeit $T_2^*$ aufweisen, mit den Verfahrensschritten
a) der Objektbereich wird in einem homogenen Magnetfield ($B_0$) angeordnet, das die Spins in eine vorgegebene Richtung (Z-Richtung) ausrichtet,
b) auf den Objektbereich wird ein Hochfrequenzpuls (RF) zur Einwirkung gebracht, der die Spins um einem vorgegebenen Flipwinkel aus der vorgegebenen Richtung herausdreht,
c) auf den Objektbereich wird mindestens ein Codierungs-Magnetfeldgradient (G-Slice, G-Phase) zur Einwirkung gebracht,
d) nach Ende des Hochfrequenzpulses (RF) wird mindestens einmal
   aa) mindestens ein Lesegradient (G-Read) mit vorgegebener Polarität für eine vorgegebene Einwirkungsdauer auf den Objektbereich zur Einwirkung gebracht;
   bb) jeder Lesegradient zum Erzeugen eines Gradientenecho-Signales in der Polarität umgeschaltet;
   cc) jeder umgeschaltete Lesegradient für eine gewünschte Lesedauer aufrechterhalten;
   dd) jeder Codierungsgradient (G-Slice; G-Phase) vor Beginn des Detektierens des Gradientenechosignales (Verfahrensschritt ee) abgeschaltet;
   ee) das durch das Umschalten erzeugte Gradientenecho-Signal detektiert;

e) jeder Lesegradient wird abgeschaltet und
f) eine vorgegebene Zeitspanne nach der Lesegradient-Abschaltung werden die Verfahrensschritte b) bis e) wiederholt,
wobei insgesamt höchstens drei Magnetfeldgradienten, die im wesentlichen aufeinander senkrecht stehen, verwendet werden, dadurch gekennzeichnet, daß
g) der Flipwinkel des Hochfrequenzpulses (RF) kleiner als 75 Grad ist und
h) die vorgegebene Zeitspanne zwischen der Lesegradient-Abschaltung (Verfahrensschritt e) und dem Anlegen des nächsten Hochfrequenzpulses (RF) wesentlich kleiner als die Spin-Gitter-Relaxationszeit $T_1$ ist.

2. Verfahren nach Anspruch 1, dadurch gekennzeichnet, daß zwischen dem Verfahrensschritt a) und der Folge der Verfahrensschritte b) bis f) eine Vorbereitungssequenz aus den Verfahrensschritten b) bis cc), e) und f) so oft durchgeführt wird, daß sich eine Gleichgewichsszustand zwischen den in der vorgegebenen Richtung (Z) ausgerichteten Spins und den aus dieser Richtung herausgedrehten Spins einstellt und die durch die folgenden Lesegradientenumschaltungen erzeugten Gradientenechosignale alle im wesentlichen die gleiche Größe haben.

3. Verfahren nach Anspruch 1, dadurch gekennzeichnet, daß zumindest bei einigen Wiederholungen der Verfahrensschritte b) bis e) die Flipwinkel von Wiederholung zu Wiederholung sukzessive erhöht werden.

4. Verfahren nach Anspruch 1, 2 oder 3, dadurch gekennzeichnet, daß der Flipwinkel des Hochfrequenzpulses höchstens 50 Grad, insbesondere höchstens 30 oder 25 Grad beträgt.

5. Verfahren nach Anspruch 1, 2, 3 oder 4, dadurch gekennzeichnet daß der Flipwinkel des Hochfrequenzpulses mindestens 10 Grad beträgt.

6. Verfahren nach einem der Ansprüche 1 bis 5, dadurch gekennzeichnet, daß die Zeitspanne zwischen der Lesegradient-Abschaltung und dem nächstfolgenden Hochfrequenzpuls höchstens 20 Millisekunden, vorzugsweise höchstens 10 Millisekunden beträgt.

7. Verfahren nach einem der vorhergehenden Ansprüche, dadurch gekennzeichnet, daß als erster Codierungsgradient ein Schichtgradient (G-Slice) während des Hochfrequenzpulses zur Einwirkung gebracht, nach Beendigung des Hochfrequenzpulses umgeschaltet und vor Beginn der Datenakquisition abgeschaltet wird und daß ferner als zweiter Codierungsgradient ein Phasengradient (G-Phase) zur Einwirkung gebracht wird, der nach dem Hochfrequenzpuls eingeschaltet und vor Beginn der Gradientenecho-Detektion abgeschaltet wird.

8. Verfahren nach einem der Ansprüche 1 bis 6, dadurch gekennzeichnet, daß als Codierungsgradienten zwei Phasengradienten (G-Phase 1; G-Phase 2) zur Einwirkung gebracht werden; daß der Verfahrensschritt d) eine vorgegebene erste Anzahl (n) mal mit schrittweise geänderten ersten Phasengradienten (G-Phase 1) und konstantem zweiten Phasengradienten (G-Phase 2) wiederholt wird und daß diese ganze Verfahrensschrittfolge dann eine vorgegebene zweite Anzahl (k) mal mit schrittweise geändertem zweiten Phasengradienten (G-Phase 2) wiederholt wird.

9. Verfahren nach einem der Ansprüche 1 bis 6, dadurch gekennzeichnet, daß als Codierungsgradient ein Schichtgradient (G-Slice während des Hochfrequenzpulses mit einer vorgegebenen Polarität aus dem Objektbereich zur Einwirkung gebracht wird, nach Beendigung des Hochfrequenzpulses in der Polarität umgekehrt und vor Beginn der Gradientenecho-Detektion abgeschaltet wird, und daß zwei Lesegradienten zur Einwirkung gebracht werden, deren Amplituden, welche während der Einwirkungsdauer vor dem Umschalten und der Lesedauer nach dem Umschalten herrschen, jeweils zwischen den Verfahrensschritten e) und f) gegenläufig umgeschaltet werden.

10. Verfahren nach einem der vorhergehenden Ansprüche, dadurch gekennzeichnet, daß die Zeitspanne zwischen dem Beginn des Hochfrequenzpulses und der ersten Lesegradienten-Umschaltung im Bereich zwischen dem Einfachen und dem Dreifachen der effektiven Spin-Spin-Relaxationszeit liegt.

11. Verfahren nach einem der vorhergehenden Ansprüche, dadurch gekennzeichnet, daß während gewisser Zeitspannen zwischen der Lesegradient-Abschaltung und dem nächstfolgenden Hochfrequenzpuls ein zusätzlicher Hochfrequenzpuls zur Einwirkung gebracht wird, während alle Gradientenfelder abeschaltet sind, wobei die Anzahl der vorgegebenen Zeitspannen höchstens 10% aller Zeitspannen gemäß Verfahrensschritt f) ist, die bei einer vorgegebenen Untersuchung des Objektbereiches auftreten.

12. Verfahren nach Anspruch 11, dadurch gekennzeichnet, daß als zusätzlicher Hochfrequenzpuls einer der folgenden Impulstypen verwendet wird: 90-Grad-Puls, 180-Grad-Puls, CHESS-Puls.

13. Spinresonanzgerät zur ortsaufgelösten Untersuchung eines Bereiches eines Objekts, der atomare Spins enthält, die eine vorgegebene Spin-Gitter-Relaxationszeit $T_1$, eine vorgegebene Spin-Spin-Relaxationszeit $T_2$ und eine vorgegebene effektive Spin-Spin-Relaxationszeit $T_2^*$ aufweisen, mit

A) einer Einrichtung (16, 25) zum Erzeugen eines homogenen Magnetfeldes ($B_0$) im Objektbereich, das die Spins in eine vorgegebene Richtung (Z-Richtung) ausrichtet,

B) einer Einrichtung (24, 30) zum Erzeugen von Hochfrequenzpulsen (HF), die auf den Objektbereich einwirken und die Spins jeweils um einen vorgegebenen Flipwinkel aus der vorgegebenen Richtung herausdrehen,

C) Einrichtungen (18, 20, 22, 28) zum Erzeugen von drei Gradienten-Magnetfeldern im Objektbereich, die im wesentlichen senkrecht zueinander verlaufen,

D) einer Einrichtung zum Empfang eines durch Spinresonanz erzeugten Signales, und

E) einer Steuereinrichtung (14) zum Steuern der die Hochfrequenzpulse erzeugenden Einrichtung (24, 30) und der die Gradienten-Magnetfelder erzeugenden Einrichtungen (18, 20, 22, 28) die so ausgebildet ist, daß während eines Zyklus zum Erzeugen von Spinresonanzdatensignalen

a) auf den Objektbereich ein Hochfrequenzpuls (RF) zur Einwirkung gebracht wird, der die Spins um einen vorgegebenen Flipwinkel aus der vorgegebenen Richtung herausdreht;

b) auf den Objektbereich mindestens ein Codierungs-Magnetfeldgradient (G-Slice, G-Phase) zur Einwirkung gebracht wird,

c) nach Ende des Hochfrequenzpulses (RF) mindestens einmal

aa) mindestens ein Lesegradient (R-Read) vorgegebener Polarität für eine vorgegebene Einwirkungsdauer auf den Objektbereich zur Einwirkung gebracht wird;

bb) jeder Lesegradient zum Erzeugen eines Gradientenecho-Signales in der Polarität umgeschaltet wird;

cc) jeder umgeschaltete Lesegradient für eine gewünschte Lesedauer aufrechterhalten wird;

dd) jeder Codierungsgradient (G-Slice; G-Phase) vor Beginn des Detektierens des Gradientenechosignales (Verfahrensschritt ee) abgeschaltet wird;

ee) das durch das Umschalten erzeugte Gradientenecho-Signal mittels der Empfangseinrichtung detektiert wird;

d) jeder Lesegradient abgeschaltet wird und

e) eine vorgegebene Zeitspanne nach der Lesegradient-Abschaltung die Verfahrensschritte a) bis d) wiederholt werden,

dadurch gekennzeichnet, daß die Steuereinrichtung so ausgebildet ist, daß

f) der Flipwinkel des Hochfrequenzpulses (RF) kleiner als 75 Grad ist und

g) die vorgegebene Zeitspanne zwischen der Lesegradient-Abschaltung (Verfahrensschritt d) und dem Anlegen des nächsten Hochfrequenzpulses (RF) wesentlich kleiner als die Spin-Gitter-Relaxationszeit $T_1$ ist.

14. Einrichtung nach Anspruch 13, dadurch gekennzeichnet, daß die Steuereinrichtung (14) so ausgebildet ist, daß vor der die Detektion des Gradientenecho-Signales enthaltenden Folge der Verfahrensschritte a) bis e) eine Vorbereitungssequenz aus den Verfahrensschritten a) bis cc), d) und e) so oft durchgeführt wird, daß sich ein Gleichgewichtszustand zwischen den in der vorgegebenen Richtung (Z) ausgerichteten Spins und den aus dieser Richtung herausgedrehten Spins einstellt und die durch die folgenden Lesegradientenumschaltungen erzeugten Gradientenechosignale alle im wesentlichen die gleiche Größe haben.

15. Einrichtung nach Anspruch 13, dadurch gekennzeichnet, daß die Steuereinrichtung (14) Mittel enthält, um zumindest bei einigen Wiederholungen der Verfahrensschritte a) bis d) die Flipwinkel von Wiederholung zu Wiederholung sukzessive zu erhöhen.

16. Einrichtung nach Anspruch 13, 14 oder 15, dadurch gekennzeichnet, daß der Flipwinkel des Hochfrequenzpulses höchstens 50 Grad, insbesondere höchstens 30 oder 25 Grad beträgt.

17. Einrichtung nach einem der Ansprüche 13 bis 16, dadurch gekennzeichnet, daß der Flipwinkel des

12

Hochfrequenzpulses mindestens 10 Grad beträgt.

18. Einrichtung nach einem der Ansprüche 13 bis 17, dadurch gekennzeichnet, daß die Steuereinrichtung (14) die Zeitspanne zwischen der Lesegradient-Abschaltung und dem nächstfolgenden Hochfrequenzpuls so steuert, daß sie höchstens 20 Millisekunden, vorzugsweise höchstens 10 Millisekunden beträgt.

19. Einrichtung nach einem der vorhergehenden Ansprüche, dadurch gekennzeichnet, daß die Steuereinrichtung (14) als ersten Codierungsgradienten einen Schichtgradienten (G-Slice) während des Hochfrequenzpulses zur Einwirkung bringt, diesen Schichtgradienten nach Beendigung des Hochfrequenzpulses umschaltet und vor Beginn der Datenakquisition abschaltet und daß die Steuereinrichtung (14) ferner als zweiten Codierungsgradienten einen Phasengradienten (G-Phase) zur Einwirkung bringt, der nach dem Hochfrequenzpuls eingeschaltet und vor Beginn der Gradientenecho-Detektion abgeschaltet wird.

20. Einrichtung nach einem der Ansprüche 13 bis 18, dadurch gekennzeichnet, daß die Steuereinrichtung (14) als Codierungsgradienten zwei Phasengradienten (G-Phase 1; G-Phase 2) zur Einwirkung bringt; daß die Steuereinrichtung (14) die Wiederholung gem. Verfahrensschritt e) eine vorgegebene erste Anzahl (n) von Malen mit in den Verfahrensschritten b) schrittweise geänderten ersten Phasengradienten (G-Phase 1) und konstantem zweiten Phasengradienten (G-Phase 2) wiederholt und diese ganze Verfahrensschrittfolge dann eine vorgegebene zweite Anzahl (k) von Malen mit schrittweise geändertem zweiten Phasengradienten (G-Phase 2) wiederholt.

21. Einrichtung nach einem der Ansprüche 13 bis 18, dadurch gekennzeichnet, daß die Steuereinrichtung (14) als Codierungsgradient einen Schichtgradienten (G-Slice) während des Hochfrequenzpulses (HF) mit einer vorgegebenen Polarität auf dem Objektbereich zur Einwirkung bringt, diesen Schichtgradienten (G-Slice) nach Beendigung des Hochfrequenzpulses in der Polarität umkehrt und vor Beginn der Gradientenecho-Detektion ausschaltet, und daß die Steuereinrichtung (14) ferner zwei Lesegradienten zur Einwirkung bringt und deren Amplituden, welche während der Einwirkungsdauer vor dem Umschalten und der Lesedauer nach dem Umschalten herrschen, jeweils zwischen den Verfahrensschritten d) und e) gegenläufig umschaltet.

22. Einrichtung nach einem der vorhergehenden Ansprüche, dadurch gekennzeichnet, daß die Steuereinrichtung (14) die erste Lesegradienten-Umschaltung eine Zeitspanne, die im Bereich zwischen dem Einfachen und dem Dreifachen der effektiven Spin-Spin-Relaxationszeit $T_2^*$ liegt, nach dem Beginn des Hochfrequenzpulses bewirkt.

23. Einrichtung nach einem der vorhergehenden Ansprüche, dadurch gekennzeichnet, daß die Steuereinrichtung (14) während gewisser Zeitspannen zwischen der Lesegradient-Abschaltung und dem nächstfolgenden Hochfrequenzpuls einen zusätzlichen Hochfrequenzpuls zur Einwirkung bringt, während alle Gradientenfelder abgeschaltet sind, wobei die Anzahl der vorgegebenen Zeitspannen höchstens 10% aller Zeitspannen gemäß Verfahrensschritt e) ist, die bei einer vorgegebenen Untersuchung des Objektbereiches auftreten.

24. Einrichtung nach Anspruch 23, dadurch gekennzeichnet, daß der zusätzliche Hochfrequenzpuls ein 90-Grad-Puls oder ein 180-Grad-Puls oder ein CHESS-Puls ist.

## Claims

1. Method for the operation of a spin resonance apparatus for the rapid acquisition of spin resonance data for a locally analyzed investigation of a region of an object, which has atomic spin, which has a predetermined spin-lattice relaxation time $T_1$, a predetermined spin-spin relaxation time $T_2$ and a predetermined effective spin-spin relaxation time $T_2^*$, with the method steps

a) the object region is arranged in a homogeneous magnetic field ($B_0$), which aligns the spin in a predetermined direction (Z-direction),

b) a high frequency pulse (RF) is caused to act on the object region, which pulse rotates the spin through a predetermined flip angle out of the predetermined direction.

c) at least one coding magnetic field gradient (G-slice, G-phase) is caused to act on the object region,

d) at the end of the high frequency pulse (RF) at least once there are

aa) at least one read gradient (G-read) caused to act on the object region with predetermined polarity for a predetermined time of action;

bb) each read gradient is inverted in polarity to create a gradient echo signal;

cc) each inverted read gradient is maintained for a desired read period;

dd) each coding gradient (G-slice; G-phase) is switched off before the beginning of the detection of the gradient echo signal (method step ee);

ee) the gradient echo signal created by the inversion is detected;

e) each read gradient is switched off and

f) a predetermined time interval after the switching off of the read gradient the method steps b) to e) are repeated,

wherein altogether at most three magnetic field gradients, which are substantially orthogonal to each other are utilised, characterized in that

g) the flip angle of the high frequency pulse (RF) is smaller than 75 degrees and

h) the predetermined time interval between the switching off of the read gradient (method step e) and the application of the next high frequency pulse (RF) is substantially smaller than the spin-lattice relaxation time $T_1$.

2. Method according to claim 1, characterized in that between the method step a) and the sequence of the method steps b) to f) a preparatory sequence of the method steps b) to cc), e) and f) is carried out so many times that an equilibrium state is established between the spins aligned in the predetermined direction (Z) and the spins rotated out of this direction and the gradient echo signals created by the following inversions of read gradient all have substantially the same magnitude.

3. Method according to claim 1, characterized in that in at least some repetitions of the method steps b) to e) the flip angle is successively increased from repetition to repetition.

4. Method according to claim 1, 2 or 3, characterized in that the flip angle of the high frequency pulse amounts at the most to 50 degrees, especially at the most to 30 or 25 degrees.

5. Method according to claim 1, 2, 3 or 4, characterized in that the flip angle of the high frequency pulse amounts to at least 10 degrees.

6. Method according to one of claims 1 to 5, characterized in that the time interval between the switching off of the read gradient and the next following high frequency pulse amounts at the most to 20 milliseconds, preferably at the most to 10 milliseconds.

7. Method according to one of the preceding claims, characterized in that a slice gradient (G-slice) is caused to act during the high frequency pulse as first coding gradient, is inverted after termination of the high frequency pulse and in that further a phase gradient (G-phase) is caused to act as second coding gradient, which is switched on after the high frequency pulse and switched off before the beginning of the gradient echo detection.

8. Method according to one of claims 1 to 6, characterized in that two phase gradients (G-phase 1; G-phase 2) are caused to act as coding gradients; in that the method step d) is repeated a predetermined first number (n) of times with stepwise varied first phase gradients (G-phase 1) and constant second phase gradients (G-phase 2) and in that this whole sequence of method steps is repeated a predetermined second number (k) of times with stepwise varied second phase gradients (G-phase 2).

9. Method according to one of claims 1 to 6, characterized in that a slice gradient (G-slice) is caused to act on the object region as coding gradient during the high frequency pulse with a predetermined polarity, is inverted in polarity after termination of the high frequency pulse and switched off before the beginning of the gradient echo detection, and in that two read gradients are caused to act, whose amplitudes which obtain during the time of action before the inversion and the read time after the inversion are each inverted in contrary sense between the method steps e) and f).

10. Method according to one of the preceding claims, characterized in that the time interval between the beginning of the high frequency pulse and the first read gradient inversion lies in the region between one times and three times the effective spin-spin relaxation time.

11. Method according to one of the preceding claims, characterized in that during certain time intervals between the read gradient inversion and the next following high frequency pulse an additional high frequency pulse is caused to act, while all gradient fields are switched off, wherein the number of the predetermined time intervals is at most 10% of all time intervals according to method step f), which occur in a predetermined investigation of the object region.

12. Method according to claim 11, characterized in that as the additional high frequency pulse there is used one of the following pulse types: 90 degree pulse, 180 degree pulse, CHESS pulse.

13. Spin resonance apparatus for a locally analyzed investigation of a region of an object, which has atomic spin, which has a predetermined spin-lattice relaxation time $T_1$, a predetermined spin-spin relaxation time $T_2$ and a predetermined effective spin-spin relaxation time $T_2^*$, with

A) a device (16, 25) for generating a homogeneous magnetic field ($B_0$) in the object region, which aligns spin in a predetermined direction (Z-direction),

B) a device (24, 30) for generating high frequency pulses (HF) which act on the object region and rotate the spin through a predetermined flip angle out of the predetermined direction,

C) devices (18, 20, 22, 28) for generating three gradient magnetic fields in the object region, which run substantially orthogonal to one another,

D) a device for receiving a signal generated by spin resonance,

E) a control device (14) for controlling the high frequency pulse generating device (24, 30) and the devices (18, 20, 22, 28) generating the gradient magnetic fields, which is so formed that, during a cycle for the generation of spin resonance data signals

a) a high frequency pulse (RF) is caused to act on the object region, which pulse rotates the spin through a predetermined flip angle out of the predetermined direction,

b) at least one coding magnetic field gradient (G-slice, G-phase) is caused to act on the object region,

c) at the end of the high frequency pulse (RF) at least once there are

aa) at least one read gradient (G-read) caused to act on the object region with predetermined polarity for a predetermined time of action;

bb) each read gradient is inverted in polarity to create a gradient echo signal;

cc) each inverted read gradient is maintained for a desired read period;

dd) each coding gradient (G-slice; G-phase) is switched off before the beginning of the detection of the gradient echo signal (method step ee);

ee) the gradient echo signal created by the inversion is detected by means of the receiving device;

d) each read gradient is switched off and

e) a predetermined time interval after the switching off of the read gradient the method steps a) to d) are repeated,

characterized in that the control device is so formed that

f) the flip angle of the high frequency pulse (RF) is smaller than 75 degrees and

g) the predetermined time inverval between the switching off of the read gradient (method step d) and the application of the next high frequency pulse (RF) is substantially smaller than the spin-

lattice relaxation time $T_1$.

14. Arrangement according to claim 13, characterized in that the control device (14) is so formed that before the sequence of method steps a) to e) containing the detection of the gradient echo signal a preparatory sequence of the method steps a) to cc), d) and e) is carried out so many times that an equilibrium state is established between the spins aligned in the predetermined direction (Z) and the spins rotated out of this direction and the gradient echo signals created by the following inversions of read gradient all have substantially the same magnitude.

15. Arrangement according to claim 13, characterized in that the control device (14) includes means whereby, in at least some repetitions of the method steps a) to d) the flip angle is successively increased from repetition to repetition.

16. Arrangement according to claim 13, 14 or 15, characterized in that the flip angle of the high frequency pulse amounts at the most to 50 degrees, especially at the most to 30 or 25 degrees.

17. Arrangement according to one of claims 13 to 16, characterized in that the flip angle of the high frequency pulse amounts to at least 10 degrees.

18. Arrangement according to one of claims 13 to 17, characterized in that the control device (14) so controls the time interval between the switching off of the read gradient and the next following high frequency pulse that it amounts at the most to 20 milliseconds, preferably at the most to 10 milliseconds.

19. Arrangement according to one of the preceding claims, characterized in that the control device (14) applies a slice gradient (G-slice) during the high frequency pulse as first coding gradient, inverts this slice gradient after termination of the high frequency pulse and before the data acquisition and in that the control device (14) further applies a phase gradient (G-phase) as second coding gradient, which is switched on after the high frequency pulse and switched off before the beginning of the gradient echo detection.

20. Arrangement according to one of claims 13 to 18, characterized in that the control device applies two phase gradients (G-phase 1; G-phase 2) as coding gradients; in that the control device (14) repeats the repetition according to method step e) a predetermined first number (n) of times with stepwise varied first phase gradients (G-phase 1) and constant second phase gradients (G-phase 2) and repeats this whole sequence of method steps a predetermined second number (k) of times with stepwise varied second phase gradients (G-phase 2).

21. Arrangement according to one of claims 13 to 18, characterized in that the control arrangement (14) applies a slice gradient (G-slice) to the object region as coding gradient during the high frequency pulse (HF) with a predetermined polarity, inverts this slice gradient (G-slice) in polarity after termination of the high frequency pulse and switches it off before the beginning of the gradient echo detection, and in that the control device (14) further applies two read gradients and whose amplitudes which obtain during the time of action before the inversion and the read time after the inversion are each inverted in contrary sense between the method steps d) and e).

22. Arrangement according to one of the preceding claims, characterized in that the control device (14) effects the first read gradient inversion an interval of time, which lies in the region between one times and three times the effective spin-spin relaxation time $T_2^*$, after the beginning of the high frequency pulse.

23. Arrangement according to one of the preceding claims, characterized in that the control device (14) during certain time intervals between the read gradient inversion and the next following high frequency pulse applies an additional high frequency pulse, while all gradient fields are switched off, wherein the number of the predetermined time intervals is at most 10% of all time intervals according to method step e), which occur in a predetermined investigation of the object region.

24. Arrangement according to claim 23, characterized in that the additional high frequency pulse is a 90 degree pulse, 180 degree pulse, or a CHESS pulse.

**Revendications**

1. Procédé pour faire fonctionner un appareil à résonance de spin pour l'acquisition rapide de données de résonance de spin pour une exploration à résolution locale d'une zone d'un objet qui contient des spins atomiques, qui présentent un temps prédéterminé de relaxation spin-réseau $T_1$, un temps prédéterminé de relaxation spin-spin $T_2$, et un temps effectif prédéterminé de relaxation spin-spin $T_2^*$, avec les phases de procédé suivantes:

a) la zone d'objet est placée dans un champ magnétique homogène ($B_0$), qui oriente les spins dans une direction prédéterminée (direction Z),

b) on fait agir sur la zone d'objet une impulsion haute fréquence (RF), qui fait tourner le spin d'un angle prédéterminée de basculement hors de l'orientation prédéterminée;

c) on fait agir sur la zone d'objet au moins un gradient de champ magnétique de codage (G-slice, G-phase),

d) à la fin de l'impulsion haute fréquence (RF), au moins une fois

aa) on fait agir au moins un gradient de lecture (G-read) ayant une polarité prédéterminée pour une durée d'action prédéterminée sur la zone d'objet,

bb) chaque gradient de lecture est commuté de polarité pour produire un signal d'écho de gradient;

cc) chaque gradient de lecture commuté est conservé pour une durée de lecture souhaitée;

dd) chaque gradient de codage (G-slice, G-phase) est arrêté avant le commencement de la détection du signal d'écho de gradient (phase du procédé ee);

ee) on détecte le signal d'écho de gradient produit par la commutation;

e) chaque gradient de lecture est arrêté et

f) on répète les phases de procédé b) à e) au bout d'une période prédéterminée après l'arrêt du gradient de lecture, dans l'ensemble trois gradients de champ magnétique au plus étant utilisés, lesquels sont disposés sensiblement verticalement l'un au-dessus de l'autre, caractérisé en ce que

g) l'angle de basculement de l'impulsion haute fréquence (RF) est inférieur à 75° et la période prédéterminée entre l'arrêt des gradients de lecture (phase de procédé e) et l'application de l'impulsion haute fréquence (RF) suivante est notablement plus courte que le temps de relaxation spin-réseau T₁.

2. Procédé selon la revendication 1, caractérisé en ce qu'on répète entre la phase de procédé a) et la séquence de phases b) à f) une séquence de préparation constituée par les phases de procédé b) à cc), e) et f), jusqu'à ce qu'il s'établisse un état d'équilibre entre les spins orientés dans la direction prédéterminée (Z) et les spins sortis par rotation de cette orientation, et en ce que les signaux d'écho de gradient produits par les commutations suivantes des gradients de lecture, ont tous sensiblement la même grandeur.

3. Procédé selon la revendication 1, caractérisé en ce qu'au moins, lors de quelques répétitions des phases b) à e) du procédé, les angles de basculement sont successivement augmentés d'une répétition à l'autre.

4. Procédé selon l'une des revendications 1, 2 ou 3, caractérisé en ce que l'angle de basculement de l'impulsion haute fréquence est 50° au plus, notamment 30 ou 25 degrés au plus.

5. Procédé selon l'une des revendications 1, 2 ou 3, caractérisé en ce que l'angle de basculement de l'impulsion haute fréquence est d'au moins 10 degrés.

6. Procédé selon l'une des revendications 1 à 5, caractérisé en ce que la période entre l'arrêt du gradient de lecture et l'impulsion haute fréquence suivante est 20 millisecondes au plus, de préférence 10 millisecondes au plus.

7. Procédé selon l'une des revendications précédentes, caractérisé en ce qu'on fait agir comme premier gradient de codage un gradient de couches (G-slice) pendant l'impulsion haute fréquence, qu'on le commute une fois l'impulsion haute fréquence terminée, qu'on l'arrête avant le commencement de l'acquisition des données, et en ce qu'en outre on fait agir comme deuxième gradient de codage un gradient de phase (G-phase), qui est mis en circuit après l'impulsion haute fréquence et mis hors circuit avant le commencement de la détection d'écho de gradient.

8. Procédé selon l'une des revendications 1 à 6, caractérisé en ce qu'on fait agir comme gradients de codage deux gradients de phase (G-phase 1; G-phase 2), en ce qu'on répète la phase de procédé d) un premier nombre prédéterminé de fois (n) avec un premier gradient de phase (G-phase 1) modifié pas à pas et un deuxième gradient de phase constant (G-phase 2), et en ce qu'on répète toute cette séquence de phases de procédé un deuxième nombre prédéterminé (k) de fois avec des seconds gradients de phase modifiés pas à pas (G-phase 2).

9. Procédé selon l'une des revendications 1 à 6, caractérisé en ce qu'on fait agir sur la zone d'objet comme gradient de codage un gradient de couches (G-slice) pendant l'impulsion haute fréquence avec une polarité prédéterminée, une fois l'impulsion haute fréquence terminée, on inverse la polarité et on l'arrête avant le commencement de la détection de l'écho de gradient, et en ce qu'on fait agir deux gradients de lecture dont les amplitudes régnant pendant la durée d'action avant la commutation et pendant la durée de lecture après la commutation, sont respectivement commutées entre les phases de procédé e) et f) en sens inverse.

10. Procédé selon l'une des revendications précédentes, caractérisé en ce que la période entre le commencement de l'impulsion haute fréquence et la première commutation du gradient de lecture se trouve dans la plage comprise entre le temps de relaxation effectif spin-spin simple et le triple de ce temps.

11. Procédé selon l'une des revendications précédentes, caractérisé en ce que, pendant certaines périodes entre l'arrêt du gradient de lecture et l'impulsion haute fréquence suivante, on fait agir une impulsion haute fréquence supplémentaire alors que tours les champs de gradients sont arrêtés, le nombre des périodes prédéterminées correspondant au plus à 10% de toutes les périodes selon la phase de procédé f) qui apparaissent lors d'une exploration prédéterminée de la zone d'objet.

12. Procédé selon la revendication 11, caractérisé en ce qu'on utilise comme impulsion haute fréquence supplémentaire un des types d'impulsions suivants: impulsion 90°, impulsion 180°, impulsion CHESS.

13. Appareil à résonance de spin pour l'exploration à résolution locale d'une zone d'un objet qui contient des spins atomiques, qui présente un temps prédéterminé de relaxation spin réseau T₁, un temps prédéterminé de relaxation spin-spin T₂ et un temps effectif prédéterminé de relaxation spin-spin T₂*, comportant

A) un dispositif (16, 25) pour produire un champ magnétique homogène (B₀) dans la zone d'objet, lequel champ oriente les spins dans une direction prédéterminée (direction Z),

B) un dispositif (24, 30) pour produire des impulsions haute fréquence (HF), qui agissent sur la zone d'objet et qui font tourner les spins chaque fois d'un angle prédéterminé de basculement hors de l'orientation prédéterminée,

C) des dispositifs (18, 20, 22, 28) pour produire dans la zone d'objet trois champs magnétiques à gradients, qui sont sensiblement perpendiculaires l'un à l'autre,

D) un dispositif pour recevoir un signal produit par la résonance de spin, et

E) un dispositif de commande (14) pour commander le dispositif (24, 30) produisant les impulsions haute fréquence et les dispositifs (18, 20, 22, 28) produisant des champs magnétiques à gradients, lequel dispositif de commande est réalisé de façon que, pendant un cycle de production de signaux de données de résonance de spin, a) on fait agir sur la zone d'objet une impulsion haute fréquence (RF), qui fait tourner les spins d'un angle de basculement prédéterminé hors de l'orientation prédéterminée;

b) on fait agir sur la zone d'objet au moins un gradient de champ magnétique de codage (G-slice, G-phase),

c) à la fin de l'impulsion haute fréquence (RF), au moins une fois

   aa) on fait agir au moins un gradient de lecture (G-read) ayant une polarité prédéterminée, pour une durée d'action prédéterminée, sur la zone d'objet;

   bb) on commute la polarité de chaque gradient de lecture pour produire un signal d'écho de gradient;

   cc) chaque gradient de lecture commuté est conservé pour une durée de lecture souhaitée;

   dd) chaque gradient de codage (G-slice, G-phase) est arrêté avant le commencement de la détection du signal d'écho de gradient (phase de procédé ee)

   ee) on détecte le signal d'écho de gradient produit par la commutation, au moyen du dispositif de réception;

d) chaque gradient de lecture est arrêté et,

e) on répète les phases de procédé a) à d) au bout d'une période prédéterminée après l'arrêt du gradient de lecture, caractérisé en ce que le dispositif de commande est réalisé de telle sorte que

f) l'angle de basculement de l'impulsion haute fréquence (RF) est inférieur à 75° et

g) la période prédéterminée entre l'arrêt du gradient de lecture (phase de procédé b) et l'application de l'impulsion haute fréquence (RF) suivante est notablement plus courte que le temps de relaxation spin-réseau $T_1$.

14. Appareil selon la revendication 13, caractérisé en ce que le dispositif de commande (14) est réalisé de telle sorte que, avant la séquence des phases de procédé a) à e) comportant la détection du signal d'écho de gradient, on répète une séquence de préparation constituée par les phases de procédé a) à cc), d) et e), jusqu'à ce qu'il s'établisse un état d'équilibre entre les spins orientés dans la direction prédéterminée (Z) et les spins sortis par rotation de cette orientation, et en ce que les signaux d'écho de gradient produits par les commutations suivantes des gradients de lecture ont tous sensiblement la même grandeur.

15. Appareil selon la revendication 13, caractérisé en ce que le dispositif de commande (14) contient des moyens pour augmenter, au moins lors de quelques répétitions des phases de procédé a) à d), les angles de basculement, successivement d'une répétition à l'autre.

16. Appareil selon l'une des revendications 13, 14 ou 15, caractérisé en ce que l'angle de basculement de l'impulsion haute fréquence est 50 degrés au plus, notamment 30 ou 25 degrés au plus.

17. Appareil selon l'une des revendications 13 à 16, caractérisé en ce que l'angle de basculement de l'impulsion haute fréquence est d'au moins 10 degrés.

18. Appareil selon l'une des revendications 13 à 17, caractérisé en ce que le dispositif de commande (14) commande la période entre l'arrêt du gradient de lecture et l'impulsion haute fréquence suivante de telle sorte qu'elle soit de 20 millisecondes au plus, de préférence de 10 millisecondes au plus.

19. Appareil selon l'une des revendications 13 à 18, caractérisé en ce que le dispositif de commande (14) fait agir comme premier gradient de codage un gradient de couches (G-slice) pendant l'impulsion haute fréquence, commute ce gradient de couches une fois l'impulsion haute fréquence terminée et l'arrête avant le commencement de l'acquisition des données, et en ce qu'en outre, le dispositif de commande (14) fait agir comme deuxième gradient de codage un gradient de phase (G-phase), qui est mis en circuit après l'impulsion haute fréquence, et est mis hors circuit avant le commencement de la détection de l'écho de gradient.

20. Appareil selon l'une des revendications 13 à 18, caractérisé en ce que le dispositif de commande (14) fait agir comme gradients de codage deux gradients de phase (G-phase 1, G-phase 2); en ce que le dispositif de commande (14) répète la phase de procédé e) un premier nombre prédéterminé de fois (n) avec un premier gradient de phase (G-phase 1) modifié pas à pas dans la phase de procédé b) et un deuxième gradient de phase (G-phase 2) constant, et en ce qu'il répète toute cette séquence de phases de procédé un deuxième nombre (k) prédéterminé de fois avec un second gradient de phase (G-phase 2) modifié pas à pas.

21. Appareil selon l'une des revendications 13 à 18, caractérisé en ce que le dispositif de commande fait agir comme gradient de codage un gradient de couches (G-slice), pendant l'impulsion haute fréquence (HF) ayant une polarité prédéterminée, sur la zone d'objet, en ce qu'il inverse la polarité de ce gradient de couches (G-slice) une fois l'impulsion haute fréquence terminée et l'arrête avant le commencement de la détection de l'écho de gradient, et en ce que le dispositif de commande (14) fait agir en outre deux gradients de lecture, dont il commute respectivement en sens inverse, entre les phases de procédé d) et e), les amplitudes régnant pendant la durée d'action, avant la commutation, et pendant la durée de lecture après la commutation.

22. Appareil selon l'une des revendications précédentes, caractérisé en ce que le dispositif de commande (14) provoque la première commutation de gradient de lecture, au bout d'une période qui se trouve dans la plage entre le temps de relaxation effectif spin-spin simple $T_2^*$ et le triple de ce temps, après le commencement de l'impulsion haute fréquence.

23. Appareil selon l'une des revendications précédentes, caractérisé en ce que le dispositif de commande (14) fait agir, pendant certaines périodes entre l'arrêt du gradient de lecture et l'impulsion haute fréquence suivante, une impulsion haute fréquence supplémentaire, alors que tous les champs de gradients sont arrêtés, le nombre des périodes prédéterminées correspondant au plus à 10% de toutes les périodes selon la phase de procédé e), qui apparaissent lors d'une exploration prédéterminée de la zone d'objet.

24. Appareil selon la revendication 23, caractérisé en ce que l'impulsion haute fréquence supplémentaire est une impulsion 90 degrés; une impulsion 180 degrés ou une impulsion CHESS.

FIG. 1

FIG. 2

RF

Signal

G-Slice

G-Phase

G-Read

$\alpha$

n mal

FIG. 3

RF

Signal

G-Slice

G-Phase

G-Read

$\alpha$

m mal

n mal

FIG. 4

RF

Signal

G-Slice

G-Phase

G-Read

$\alpha$

$n_{mal}$  $k_{mal}$  FIG. 5

RF

Signal

G-Slice

G-Phase

G-Read

$\alpha$, SLICE k

$n_{mal}$  $k_{mal}$  FIG. 6

RF

Signal

G-Phase 1

G-Phase 2

G-Read

$\alpha$

$n \times k$ mal

FIG. 7

RF

Signal

G-Phase 1

G-Phase 2

G-Read

$\alpha$,CHESS

$n \times k$ mal

FIG. 8

FIG. 9

FIG.10

FIG.11

EP 0 191 431 B1

| Intervall | 0 | 1 | 2 | 3 | 4 | 5 | 6 | 7 | 8 | 9 | 10 | 11 | 12 | 13 | 14 | 15 |
|-----------|---|---|---|---|---|---|---|---|---|---|----|----|----|----|----|----|

RF-Puls

RF-Frequenz

G-Slice

G-Phase

G-Read

Datenaufnahme

Dauer

| 4.9 ms | 2.0 ms | 2.35 ms | 0.35 ms | 2.5 ms | 5.0 ms | 0.1 ms | 4.9 ms | 2.0 ms | 2.35 ms | 0.35 ms | 2.5 ms | 5.0 ms | 0.1 ms | 4.9 ms | 150 ms |

17.2 ms          17.2 ms

FIG.12

FIG. 16

FIG.13
TEIL 1

FIG.13
TEIL 2

EP 0 191 431 B1

FIG.13
TEIL 3

FIG. 14

FIG.15
TEIL 1

FIG.15
TEIL 2

FIG.15
TEIL 3